(19) **Europäisches Patentamt European Patent Office Office européen des brevets**

(11) **EP 4 048 745 B1**

(12) **EUROPEAN PATENT SPECIFICATION**

(45) Date of publication and mention
of the grant of the patent:
**02.04.2025 Bulletin 2025/14**

(21) Application number: **20878462.9**

(22) Date of filing: **22.10.2020**

(51) International Patent Classification (IPC):
*C09G 1/02* *(2006.01)*     *C09K 3/14* *(2006.01)*
*H01L 21/3105* *(2006.01)*     *H01L 21/02* *(2006.01)*
*B24B 37/04* *(2012.01)*     *C01F 17/235* *(2020.01)*

(52) Cooperative Patent Classification (CPC):
**B24B 37/044; C01F 17/235; C09G 1/02;**
**C09K 3/1409; C09K 3/1463;** C01P 2002/54;
C01P 2004/38; C01P 2004/51; C01P 2004/62;
C01P 2004/64; C01P 2006/12; C01P 2006/90

(86) International application number:
**PCT/US2020/056752**

(87) International publication number:
**WO 2021/081148 (29.04.2021 Gazette 2021/17)**

(54) **COMPOSITION AND METHOD FOR DIELECTRIC CMP**

ZUSAMMENSETZUNG UND VERFAHREN FÜR DIELEKTRISCHEN CMP

COMPOSITION ET PROCÉDÉ CMP DIÉLECTRIQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **22.10.2019 US 201962924328 P**

(43) Date of publication of application:
**31.08.2022 Bulletin 2022/35**

(73) Proprietor: **CMC Materials LLC**
**Wilmington, DE 19801 (US)**

(72) Inventors:
• **BROSNAN, Sarah**
  **Aurora, Illinois 60504 (US)**
• **KRAFT, Steven**
  **Aurora, Illinois 60504 (US)**
• **HUNG LOW, Fernando**
  **Aurora, Illinois 60504 (US)**

• **PETRO, Benjamin**
  **Aurora, Illinois 60504 (US)**
• **ZHANG, Na**
  **Aurora, Illinois 60504 (US)**
• **TRUFFA, Julianne**
  **Aurora, Illinois 60504 (US)**
• **PALLIKKARA KUTTIATOOR, Sudeep**
  **Aurora, Illinois 60504 (US)**

(74) Representative: **Barker Brettell LLP**
**100 Hagley Road**
**Edgbaston**
**Birmingham B16 8QQ (GB)**

(56) References cited:
EP-A1- 3 257 910     WO-A1-2018/229005
WO-A1-2019/187977     CN-A- 103 866 327
KR-A- 20170 073 857     US-A1- 2004 223 898
US-A1- 2006 099 814     US-A1- 2017 066 102
US-A1- 2017 166 778

**Description**

CROSS REFERENCE TO RELATED APPLICATIONS

This application claims the benefit of U.S. Provisional Application Ser. No. 62/924,328 entitled Composition and Method for Dielectric CMP, filed October 22, 2019.

BACKGROUND OF THE INVENTION

Chemical mechanical polishing is a key enabling technology in integrated circuit (IC) and micro-electro-mechanical systems (MEMS) fabrication. CMP compositions and methods for polishing (or planarizing) the surface of a substrate (such as a wafer) are well known in the art. Polishing compositions (also known as polishing slurries, CMP slurries, and CMP compositions) commonly include abrasive particles suspended (dispersed) in an aqueous solution and chemical additives for increasing the rate of material removal, improving planarization efficiency, and/or reducing defectivity during a CMP operation.

Cerium oxide (ceria) abrasives are well known in the industry, particularly for polishing silicon containing substrates, for example, including silicon oxide materials, such as tetraethylorthosilicate (TEOS), silicon nitride, and/or polysilicon. Ceria abrasive compositions are commonly used in advanced dielectric applications, for example including shallow trench isolation applications. While the use of ceria abrasives is known, there remains a need for improved ceria abrasive based CMP compositions. In particular, there remains a need for CMP compositions that provide improved removal rates and improved planarization (e.g., reduced erosion and dishing). There further remains a need for compositions providing removal rate selectivity of one silicon containing material to another (e.g., silicon oxide to silicon nitride selectivity or silicon oxide to polysilicon selectivity).

BRIEF SUMMARY OF THE INVENTION

A chemical mechanical polishing composition for polishing a substrate having a silicon oxygen material (such as silicon oxide) is disclosed. In one embodiment, the polishing composition comprises, consists of, or consists essentially of a liquid carrier, cubiform ceria abrasive particles dispersed in the liquid carrier, and a cationic polymer having a charge density of greater than about 6 milliequivalents per gram (meq/g).

BRIEF DESCRIPTION OF THE DRAWINGS

For a more complete understanding of the disclosed subject matter, and advantages thereof, reference is now made to the following descriptions taken in conjunction with the accompanying drawings, in which:

FIGS. 1 and 2 depict transmission electron microscopy (TEM) micrographs of a cubiform ceria abrasive sample showing ceria abrasive particles having square faces.
FIG. 3 depicts a scanning electron microscopy (SEM) micrograph of a cubiform ceria abrasive sample showing ceria abrasive particles having square faces.

DETAILED DESCRIPTION OF THE INVENTION

A chemical mechanical polishing composition for polishing a substrate having a silicon oxygen material (such as silicon oxide) is disclosed. The polishing composition comprises, consists of, or consists essentially of a liquid carrier, cubiform ceria abrasive particles dispersed in the liquid carrier, and a cationic polymer having a charge density of greater than about 6 milliequivalents per gram (meq/g). The cationic polymer may include, for example, ε-polylysine and/or poly(vinylimidazolium).

The disclosed polishing compositions and corresponding (CMP methods) may confer significant and unexpected advantages. For example, the disclosed compositions may provide significantly improved silicon oxide removal rates and may therefore improve throughput and save time and money. In certain embodiments, the disclosed compositions may further provide reduced silicon nitride removal rates and significantly improved silicon oxide to polysilicon selectivity. The disclosed composition may further provide improved dishing and erosion over a wide range pattern features and densities.

The polishing composition contains abrasive particles including cubiform cerium oxide abrasive particles suspended in a liquid carrier. By "cubiform" it is meant that the ceria abrasive particles are in the form or shape of a cube, i.e., substantially cubic. Stated another way, the cubiform ceria abrasive particles are cubic in form or nature. However, it will be understood that the edge dimensions, corners, and corner angles need not be exactly or precisely those of a perfect cube. For example, the cubiform abrasive particles may have slightly rounded or chipped corners, slightly rounded edges, edge dimensions that are not exactly equal to one another, corner angles that are not exactly 90 degrees, and/or other minor irregularities and still retain the basic form of cube. One of ordinary skill in the art will be readily able to recognize (e.g., via scanning electron microscopy or transmission electron microscopy) that the cubiform ceria abrasive particles are cubic in form with tolerances generally allowed for particle growth and deagglomeration.

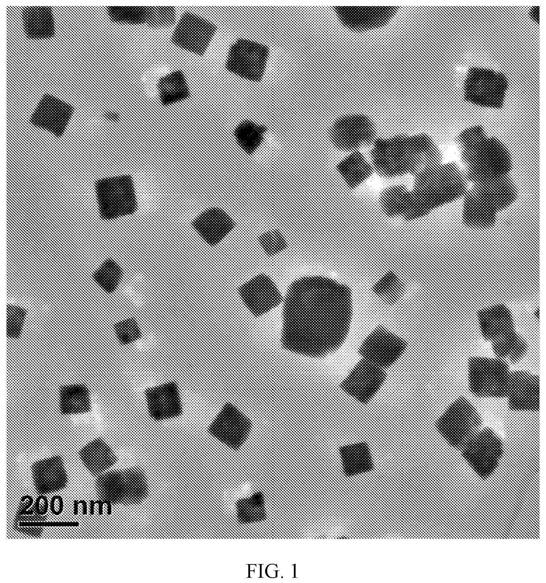

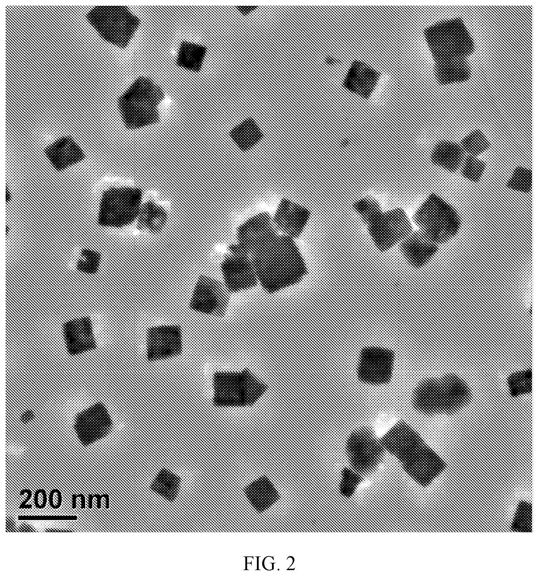

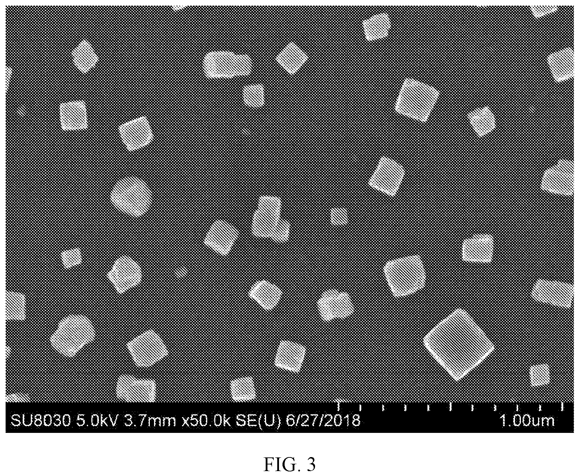

FIGS. 1, 2, and 3 depict example cubiform ceria abrasive particles. These transmission electron microscopy (TEM) and scanning electron microscopy (SEM) images depict ceria abrasive particles having square faces. For example, in these images the depicted particle faces each include four edges having substantially the same length (e.g., within 20 percent of one another or even within 10 percent or less of one other). Moreover the edges meet at corners at approximately 90 degree angles (e.g., within a range from about 80 to 100 degrees or from about 85 to about 95 degrees). One of ordinary skill in the art will readily appreciate that in the TEM and SEM images a significant majority of the depicted abrasive particles are cubiform in that they have square faces as defined above. Some of the particles may be observed to include defects, for example, on one or more corners. Again, it will be understood that the term cubiform is not intended to describe ceria abrasive particles that are precisely cubic, but rather particles that are generally cubic in nature as described above and depicted in FIGS 1, 2, and 3.

As used herein, a chemical mechanical polishing composition including a cubiform ceria abrasive is one in which at least 25 number percent of the abrasive particles are cubic in nature (cubic in form or shape as described above). In preferred embodiments, at least 40 number percent (e.g., at least 60 percent, or at least 80 percent) of the abrasive particles are cubic in nature. As noted above, the cubiform ceria abrasive particles may be readily evaluated and counted using TEM or SEM images, for example, at a magnification in a range from about 10,000x to about 500,000x. SEM or TEM images show abrasive particles having faces with four sides with similar length (e.g., within 20 percent of one another as described above). The images also show that adjacent sides are approximately perpendicular, for example, forming an angle of about 90 degrees (e.g., within a range from about 80 to about 100 degrees as also described above). To determine whether or not a ceria abrasive composition includes cubiform ceria abrasive particles, SEM or TEM observation shall be made on a large number of randomly selected particles (i.e., more than 200) so that it is possible to perform a statistical analysis and thereby determine a percentage of the particles that have a square face. The particles retained must be such that their images are well visible on the micrographs. Some of the particles may exhibit some defects either on their surface and/or one or more of their corners and still be counted as being cubiform.

The cubiform ceria abrasive particles may be substantially pure ceria abrasive particles (within normal tolerances for impurities) or doped ceria abrasive particles. Doped ceria abrasive particles may include interstitial dopants (dopants that occupy a space in the lattice that is not normally occupied) or substitutional dopants (dopants that occupy a space in the lattice normally occupied by cerium or oxygen atoms). Such dopants may include substantially any metal atom, for example, including Ca, Mg, Zn, Zr, Sc, or Y.

In certain advantageous embodiments, the dopants may include one or more Lanthanides, for example, including lanthanum, praseodymium, neodymium, promethium, samarium, and the like. In one particularly suitable embodiment, the cubiform ceria abrasive particles include a mixed oxide of cerium and lanthanum. The mixed oxide abrasive particles may have a molar ratio of La to (La + Ce) in range from about 0.01 to about 0.15, for example, from about 0.01 to about 0.12. It will be understood that such abrasive particles may additionally include other elements and/or oxides (e.g., as impurities). Such impurities may originate from the raw materials or starting materials used in the process of preparing the abrasive particles. The total proportion of the impurities is preferably less than 0.2% by weight of the particle. Residual nitrates are not considered as impurities.

In certain embodiments, the molar ratio of La to (La + Ce) may be in a range from about 0.01 to about 0.04 (e.g., from about 0.02 to about 0.03). In one such embodiment, the cubiform ceria abrasive particles include about 2.5 mole percent lanthanum oxide and about 97.5 mole percent cerium oxide. In other embodiments, the molar ratio may be in a range from about 0.08 to about 0.12 (e.g., from about 0.09 to about 0.11). In one such other embodiment the cubiform ceria abrasive particles include about 10 mole percent lanthanum oxide and about 90 mole percent cerium oxide. The abrasive particles may be a single phase solid solution with the lanthanum atoms substituting cerium atoms in the cerium oxide crystalline structure. In one embodiment, the solid solution exhibits a symmetrical x-ray diffraction pattern with a peak located between about 27 degrees and about 29 degrees that is shifted to a lower angle than pure cerium oxide. A solid solution may be obtained when the temperature of the aging sub-step (described below) is higher than about 60 degrees C. As used herein the term "solid solution" means that x-ray diffraction shows only the pattern of the cerium oxide crystal structure with or without shifts in the individual peaks but without additional peaks that would indicate the presence of other phases.

The cubiform ceria abrasive particles may also optionally be characterized by their specific surface area as determined on a powder by adsorption of nitrogen using the Brunauer-Emmett-Teller method (BET method). The method is disclosed in ASTM D3663-03 (reapproved 2015). The abrasive particles may have a specific surface area in a range from about 3 to about 14 $m^2/g$ (e.g., from about 7 to about 13 $m^2/g$ or from about 8 to about 12 $m^2/g$).

The cubiform ceria abrasive particles may optionally also be characterized by their average particle size and/or particle size distribution. The abrasive particles may have an average particle size in a range from about 50 nm to about 1000 nm (e.g., from about 80 nm to about 500 nm, from about 80 nm to about 250 nm, from about 100 nm to about 250 nm, or from about 150 nm to about 250 nm). Moreover, the average particle size may be greater than about 50 nm (e.g., greater than about 80 nm or greater than about 100 nm). The average particle size may be determined via dynamic light scattering (DLS) and corresponds to a median particle diameter (D50). DLS measurements may be made, for example, using a Zetasizer (available from Malvern Instruments). Those of ordinary skill in the art will readily appreciate that DLS measurements may significantly under count small particles when measured in the presence of comparatively larger particles. For the cubiform ceria abrasive particles disclosed herein the DLS technique tends to under count particles below about 40 nm. It will be understood that the disclosed embodiments may include a significant number of such small particles (less than 40 nm) that are not counted by DLS and therefore do not contribute to the average particles size.

Laser diffraction techniques may also optionally be used to characterize particle size distribution. Those of ordinary skill in the art will readily appreciate that laser diffraction techniques also tend to under count small particles (e.g., less than 40 nm in the disclosed embodiments). Laser diffraction measurements may be made, for example, using the Horiba LA-960 using a relative refractive index of 1.7. From the distribution obtained with laser diffraction measurements, various parameters may be obtained, for example, including D10, D50, D90, D99 and the dispersion index (defined below). Based on laser diffraction measurements, the abrasive particles may include a median diameter (D50) in a range from about 100 nm to about 700 nm (e.g., from about 100 nm to about 200 nm). For example, D50 may be in a range from about 100 nm to about 150 nm or from about 150 nm to about 200 nm. D50 is the median diameter determined from a distribution obtained by laser diffraction.

The cubiform ceria abrasive particles may optionally have a D10 in a range from about 80 nm to about 400 nm (e.g., from about 80 nm to about 250 nm, from about 80 nm to about 150 nm, or from about 100 nm to about 130 nm). It will be understood that D10 represents the particle diameter obtained by laser diffraction for which 10% of the particles have a diameter of less than D10.

The cubiform ceria abrasive particles may optionally have a D90 in a range from about 150 nm to about 1200 nm (e.g., from about 150 nm to about 1000 nm, from about 150 to about 750 nm, from about 150 to about 500 nm, from about 150 to about 300 nm, or from about 200 nm to about 300 nm). D90 represents the particle diameter obtained by laser diffraction for which 90% of the particles have a diameter of less than D90. Abrasive particles having undergone mechanical deagglomeration may have a D90 less than about 300 nm.

The cubiform ceria abrasive particles may optionally exhibit a low dispersion index. The "dispersion index" is defined by the following formula dispersion index = (D90-D10)/2·D50. The dispersion index may be less than about 0.60, for example (less than about 0.5, less than about 0.4, or less than about 0.30). Abrasive particles having undergone mechanical deagglomeration may have a dispersion index less than about 0.30. Moreover, D90/D50 may be in a range from about 1.3 to about 2 for particles having undergone mechanical deagglomeration.

The cubiform ceria abrasive particles may optionally have a D99 in a range from about 150 nm to about 3000 nm (e.g., from about 200 nm to about 2000 nm, from about 200 nm to about 1800 nm, from about 200 to about 1200 nm, from about 200 to about 900, from about 200 nm to about 600 nm, from about 200 to about 500 nm, or from about 200 to about 400 nm). Abrasive particles having undergone mechanical deagglomeration may have a D99 less than about 600 nm (e.g., less than about 500 or less than about 400). D99 represents the particle diameter obtained by laser diffraction for which 99% of the particles have a diameter of less than D99.

The abrasive particles may be prepared using substantially any suitable methodology for producing cubiform ceria abrasive particles. The disclosed embodiments are directed to chemical mechanical polishing compositions including such abrasive particles and to methods for polishing substrates using such abrasive particles and are not limited to any particular methods for producing the particles. In certain embodiments, the cubiform ceria abrasive particles may be prepared by precipitating cerium nitrates (and optionally other nitrates when a doped ceria abrasive is prepared). The precipitated material may then be grown in a specific temperature and pressure regime to promote growth of cubiform ceria abrasive particles. These particles may then be cleaned and deagglomerated. A dispersion of the cubiform ceria abrasive particles may then be prepared and used to formulate the inventive chemical mechanical compositions.

In one advantageous embodiment cubiform cerium lanthanum oxide abrasive particles may be prepared by precipitating nitrates of cerium and of lanthanum. One such preparation method includes the following steps:

(i) Mixing, under an inert atmosphere, an aqueous cerium nitrate solution and an aqueous base.
(ii) Heating the mixture obtained in (i) under an inert atmosphere.
(iii) Optionally acidifying the heat treated mixture obtained in (ii).
(iv) Washing with water the solid material obtained in (ii) or (iii).
(v) Mechanically treating the solid material obtained in (iv) to deagglomerate the ceria particles.

The cerium nitrate solution used in step (i) of the above methodology may be prepared by mixing aqueous solutions of cerium nitrates and lanthanum nitrates. The aqueous solution comprises $Ce^{III}$, $Ce^{IV}$ and $La^{III}$ and may be characterized by a Ce$^{IV}$ to total Ce molar ratio between about 1/(500,000) and about 1/(4,000). In one example embodiment the molar ratio may be between about 1/(100,000) and about 1/(90,000). It is generally advantageous to use salts and ingredients of a high purity, for example, having a purities of at least 99.5 weight percent or even 99.9 weight percent.

Step (i) includes mixing/reacting the aqueous cerium nitrate solution with an aqueous base. Bases of the hydroxide type may be advantageous, for example, including alkali metal or alkaline earth metal hydroxides and aqueous ammonia. Secondary, tertiary or quaternary amines may also be used. The aqueous solution of the base may also be degassed (deoxygenated) beforehand by bubbling with an inert gas. The mixing may be implemented by introducing the aqueous cerium nitrate solution into the aqueous base and is advantageously carried out under an inert atmosphere, for example, in a closed reactor or in a semi-closed reactor with inert gas (e.g., nitrogen or argon) purging. The mixing may also be carried out with stirring. The molar ratio of base to (Ce + La) may be between about 8.0 and about 30.0 (e.g., greater than about 9.0). Step (i) may further be carried out at a temperature between about 5 degrees C and about 50 degrees C, for example, between about 20 degrees C and 25 degrees C.

Step (ii) includes heating the mixture obtained at the end of the preceding step and may include a heating sub-step and an aging sub-step. The heating sub-step may include heating the mixture to a temperature in range from about 75 degrees C to about 95 degrees C, for example, from about 85 degrees C to about 90 degrees C. The aging sub-step may include maintaining (holding) the mixture at the temperature for a duration in a range from about 2 hours to about 20 hours. In general the aging time decreases with increasing temperature. Step (ii) may also be carried out under an inert atmosphere and stirring as described above for step (i).

In step (iii), the mixture obtained at the end of step (ii) may optionally be acidified, for example, using nitric acid. The heat treated reaction mixture may be acidified, for example, to a pH lower than about 3.0 (e.g., in a range from about 1.5 to about 2.5).

In step (iv), the solid material obtained in step (ii) or (iii) may be washed with water, (e.g., deionized water). The washing may be used to decrease residual nitrates in the final dispersion and to obtain a targeted conductivity. The washing may include filtering the solid from the mixture and redispersing the solid in water. Filtration and redispersion may be performed several times if necessary.

In step (v), the washed solid material obtained in (iv) may optionally be mechanically treated to deagglomerate or partially deagglomerate the ceria abrasive particles. Mechanical treatment may include, for example, double jet treatment or ultrasonic deagglomeration and usually results in a narrow particle size distribution and to a reduction of the number of large agglomerated particles.

After step (iv) or (v), the solid material may be dried to obtain the cerium-based particles in the powder form. The powder may be redispersed by adding water or a mixture of water and of a miscible liquid organic compound to obtain a dispersion of the cerium-based particles in a liquid medium. The liquid medium may be water or a mixture of water and of a water-miscible organic liquid. The water-miscible organic liquid may, for example, include an alcohol such as isopropyl alcohol, ethanol, 1-propanol, methanol, 1-hexanol; a ketone such as acetone, diacetone alcohol, methyl ethyl ketone; an ester such as ethyl formate, propyl formate, ethyl acetate, methyl acetate, methyl lactate, butyl lactate, ethyl lactate. The proportion of water to organic liquid may be between 80 to 20 and 99 to 1 parts by weight. Moreover, the dispersion may include from about 1 weight percent to about 40 weight percent of the cerium-based particles, e.g., between about 10 weight percent and about 35 weight percent. The dispersion may also have a conductivity less than about 300 µS/cm, for example, less than about 150 more particularly lower than 150 µS/cm or less than about 100 µS/cm.

The polishing composition may include substantially any suitable amount of the cubiform ceria abrasive particles. For example, the polishing composition may include about 0.0001 weight percent (1 ppm by weight) or more of the cubiform ceria abrasive particles at point of use (e.g., about 0.001 weight percent or more, about 0.005 weight percent or more, about 0.01 weight percent or more, about 0.02 weight percent or more, about 0.05 weight percent or more, or about 0.1 weight percent or more). The polishing composition may include about 10 weight percent or less of the cubiform ceria abrasive particles at point of use (e.g., about 5 weight percent or less, about 2 weight percent or less, about 1.5 weight percent or less, about 1 weight percent or less, about 0.5 weight percent or less, or about 0.2 weight percent or less). It will be understood that the cubiform ceria abrasive particles may be present in the polishing composition at a concentration bounded by any two of the aforementioned endpoints. For example, the concentration of cubiform ceria abrasive particles in the polishing composition may be in a range from about 0.0001 weight percent to about 10 weight percent at point of use (e.g., from about 0.001 weight percent to about 1 weight percent, from about 0.005 weight percent to about 1 weight percent, from about 0.005 weight percent to about 0.5 weight percent, or from about 0.005 weight percent to about 0.2 weight percent).

An aqueous liquid carrier is used to facilitate the application of the abrasive and any optional chemical additives to the surface of the substrate to be polished (e.g., planarized). By aqueous it is meant that the liquid carrier is made up of at least 50 wt. % water (e.g., deionized water). The liquid carrier may include other suitable non-aqueous carriers, for example, including lower alcohols (e.g., methanol, ethanol, etc.) and ethers (e.g., dioxane, tetrahydrofuran, etc.). Preferably, the liquid carrier consists essentially of or consists of water, and more preferably deionized water.

The polishing composition is generally acidic or mildly acidic having a pH of less than about 7. The polishing composition may have a pH of about 2 or more (e.g., about 3 or more or about 3.5 or more). Moreover, the polishing composition may have a pH of about 7 or less (e.g., about 6 or less or about 5 or less). It will be understood that the polishing composition may have a pH in a range bounded by any two of the aforementioned endpoints, for example, in a range from about 2 to about 7 (e.g., from about 3 to about 6, from about 3 to about 5, or from about 3.5 to about 5). For example, in certain embodiments, the pH of the composition may be about 4. In other embodiments, the pH of the composition may be about 5.

The polishing composition further comprises a cationic polymer. The cationic polymer may include substantially any suitable cationic polymer, for example, a cationic homopolymer, a cationic copolymer including at least one cationic monomer (and an optional nonionic monomer), and combinations thereof.

The cationic polymer may be substantially any suitable cationic homopolymer including cationic monomer repeat units, for example, including quaternary amine groups as repeat units. The quaternized amine groups may be acyclic or incorporated into a ring structure. Quaternized amine groups include tetrasubstituted nitrogen atoms substituted with four groups independently selected from alkyl, alkenyl, aryl, arylalkyl, acrylamido, or methacrylate groups. When included into a ring structure, quaternized amine groups include either a heterocyclic saturated ring including a nitrogen atom and are further substituted with two groups as described above or a heteroaryl group (e.g., imidazole or pyridine) having a further group as described above bonded to the nitrogen atom. Quaternized amine groups possess a positive charge (i.e., are cations having associated anionic moieties, thereby forming salts). It is also suitable for the cationic polymer to be further modified by alkylation, acylation, ethoxylation, or other chemical reaction, in order to alter the solubility, viscosity, or other physical parameter of the cationic polymer. Suitable quaternary amine monomers include, for example, quaternized vinylimidazole (vinylimidazolium), methacryloyloxyethyltrimethylammonium (MADQUAT), diallyldimethylammonium (DADMA), methacrylamidopropyl trimethylammonium (MAPTA), quaternized dimethylaminoethyl methacrylate (DMAEMA), epichlorohydrin-dimethylamine (epi-DMA), cationic poly(vinyl alcohol) (PVOH), quaternized hydroxyethylcellulose, and combinations thereof. It will be appreciated that MADQUAT, DADMA, MAPTA, and DMAEMA commonly include a counter anion such as a carboxylate (e.g., acetate) or a halide anion (e.g., chloride). The disclosed embodiments are not limited in this regard.

The cationic polymer may also be a copolymer including at least one cationic monomer (e.g., as described in the preceding paragraph) and at least one nonionic monomer. Non-limiting examples of suitable nonionic monomers include vinylpyrrolidone, vinylcaprolactam, vinylimidazole, acrylamide, vinyl alcohol, polyvinyl formal, polyvinyl butyral, poly(vinyl phenyl ketone), vinylpyridine, polyacrolein, cellulose, hydroxylethyl cellulose, ethylene, propylene, styrene, and combinations thereof.

Example cationic polymers include but are not limited to poly(vinylimidazolium), poly(methacryloyloxyethyltrimethylammonium) (polyMADQUAT), poly(diallyldimethylammonium) (e.g., polyDADMAC) (i.e., Polyquaternium-6), poly(dimethylamine-co-epichlorohydrin), poly[bis(2-chloroethyl) ether-alt-1,3-bis[3-(dimethylamino)propyl]urea] (i.e., Polyquaternium-2), copolymers of hydroxyethyl cellulose and diallyldimethylammonium (i.e., Polyquaternium-4), copolymers of acrylamide and diallyldimethylammonium (i.e., Polyquaternium-7), quaternized hydroxyethylcellulose ethoxylate (i.e., Polyquaternium-10), copolymers of vinylpyrrolidone and quaternized dimethylaminoethyl methacrylate (i.e., Polyquaternium-11), copolymers of vinylpyrrolidone and quaternized vinylimidazole (i.e., Polyquaternium-16), Polyquaternium-24, a terpolymer of vinylcaprolactam, vinylpyrrolidone, and quaternized vinylimidazole (i.e., Polyquaternium-46), 3-Methyl-1-vinylimidazolium methyl sulfate-N-vinylpyrrolidone copolymer (i.e., Polyquaternium-44), and copolymers of vinylpyrrolidone and diallyldimethylammonium. Additionally, suitable cationic polymers include cationic polymers for personal care such as Luviquat® Supreme, Luviquat® Hold, Luviquat® UltraCare, Luviquat® FC 370, Luviquat® FC 550, Luviquat® FC 552, Luviquat® Excellence, GOHSEFIMER K210™, GOHSENX K-434, and combinations thereof.

In certain embodiments, the cationic polymer may include an amino acid monomer (such compounds may also be referred to as polyamino acid compounds). Suitable polyamino acid compounds may include substantially any suitable amino acid monomer groups, for example, including polyarginine, polyhistidine, polyalanine, polyglycine, polytyrosine, polyproline, and polylysine. In certain embodiments, polylysine is a preferred polyamino acid. It will be understood that polylysine may include ε-polylysine and/or α-polylysine composed of D-lysine and/or L-lysine. The polylysine may thus include α-poly-L-lysine, α-poly-D-lysine, ε-poly-L-lysine, ε-poly-D-lysine, and mixtures thereof. In certain embodiments, the polylysine may be ε-poly-L-lysine. It will further be understood that the polyamino acid compound (or compounds) may be used in any accessible form, e.g., the conjugate acid or base and salt forms of the polyamino acid may be used instead of (or in addition to) the polyamino acid.

The cationic polymer may also (or alternatively) include a derivatized polyamino acid (i.e., a cationic polymer containing a derivatized amino acid monomer unit). For example, the derivatized polyamino acid may include derivatized polyarginine, derivatized polyornithine, derivatized polyhistidine, and derivatized polylysine. CMP compositions including derivatized polyamino acid compounds are disclosed in U.S. Provisional Patent Application Serial No. 62/958,033, which is incorporated by reference herein in its entirety.

In such embodiments, the derivatized amino acid monomer includes a derivative group bonded to the alpha amino group of the derivatized amino acid monomer. The derivative group may include substantially any suitable group, for example, including an alkyl carbonyl group, a divalent carboacyl group, an alkyl urea group, an alkyl sulfonate group, an alkyl sulfone group, and an alkyl ester group.

Example alkyl carbonyl groups include an acetyl group, a pivaloyl group, an ethyl carbonyl group, and the like. Example divalent carboacyl groups include a succinyl group, an octenyl succinyl group, a glutaric group, a methyl succinyl group, and the like. Among divalent carboacyl groups, a succinyl group and a glutaric group may be preferred owing to solubility. Example alkyl urea groups include ethyl urea, butyl urea, cyclohexyl urea, and the like. Example alkyl sulfonate groups include methyl sulfonate, dimethyl sulfonate, ethyl sulfonate, propyl sulfonate, butyl sulfonate, penta sulfonate, and the like. Example alkyl sulfone groups include methyl sulfone, ethyl sulfone, propyl sulfone, butyl sulfone, penta sulfone, and the like. Example alkyl ester groups include methyl ester, ethyl ester, propyl ester, butyl ester, penta ester, and the like.

A most preferred derivatized polyamino acid includes succinylated epsilon polylysine (a derivatized polylysine in which the derivative group is a succinyl group).

The cationic polymer may have substantially any suitable molecular weight. For example, the cationic polymer may have an average molecular weight of about 200 g/mol or more (e.g., about 500 g/mol or more, about 1,000 g/mol or more, about 2,000 g/mol or more, about 5,000 g/mol or more, or about 10,000 g/mol or more). The cationic polymer may have an average molecular weight of about 5,000,000 g/mol or less (e.g., about 2,000,000 g/mol or less, about 1,000,000 g/mol or less, about 800,000 g/mol or less, about 600,000 g/mol or less, or about 500,000 g/mol or less). Accordingly, it will be understood that the cationic polymer may have an average molecular weight bounded by any two of the aforementioned endpoints. For example, the cationic polymer may have an average molecular weight of about 200 g/mol to about 5,000,000 g/mol (e.g., about 1,000 g/mol to about 2,000,000 g/mol, or about 2,000 g/mol to about 2,000,000g/mol).

In a first group of the disclosed polishing compositions, the cationic polymer may be characterized as having a high charge density (e.g., a charge density greater than about 6 meq/g). In a second group of the disclosed polishing compositions, the cationic polymer may be characterized as having a low charge density (e.g., a charge density less than about 6 meq/g).

The charge density of a polymer may be defined as the number of charges per the average molecular weight of the monomer repeat unit(s). The charge density may be calculated for many polymers when the molecular structure of the monomer is known and additionally for copolymers when the molar ratios of the monomers are known. As used herein, charge density is expressed in units of milliequivalents per gram (meq/g) and is computed by dividing the number of charges by the average molecular weight of the monomer repeat unit(s) and then multiplying by 1000, as follows for a homopolymer:

$$CD = \frac{1000 \cdot q}{MW_{mon}} \qquad (1)$$

where $CD$ represents the charge density of the polymer, $MW_{mon}$ represents the molecular weight of the monomer, and $q$ represents the number of charges per monomer unit (commonly 1). For example, a hypothetical homopolymer in which the monomer has a single positive charge and a molecular weight of 120 g/mol would have a charge density of 8.3 (i.e., $1000 \cdot 1/120$).

More generally, the charge density of substantially any polymer including those having more than one monomer unit (e.g., a copolymer, a terpolymer, etc.) may be expressed mathematically, for example as follows:

$$CD = \frac{1000 \cdot (n_1 \cdot q_1 + n_2 \cdot q_2 + \cdots + n_x \cdot q_x)}{n_1 \cdot MW_1 + n_2 \cdot MW_2 + \cdots + n_x \cdot MW_x} \qquad (2)$$

where $CD$ represents the charge density, $MW_1$, $MW_2$ ...$MW_x$ represent the molecular weights of the first, second, and xth monomer units that make up the polymer, $q_1$, $q_2$ ... $q_x$ represent the number of charges on each of the monomer units that make up the polymer (e.g., 1 and 0 for common copolymers), and $n_1$, $n_2$, ... $n_x$ represent the mole fractions of the monomer units that make up the polymer. For example, a hypothetical copolymer including 30 molar percent of a cationic monomer with a single positive charge and a molecular weight of 100 g/mol and 70 molar percent of a neutral monomer having a molecular weight of 50 g/mol would have a charge density of 4.6 (i.e., $1000 \cdot (0.3 \cdot 1 + 0.7 \cdot 0)/(0.3 \cdot 100 + 0.7 \cdot 50)$).

For the purposes of this disclosure, the charge densities of cationic homopolymers are calculated using Equation (1) and the charge densities of cationic copolymers, terpolymers, etc. are calculated using Equation (2) as described above. Those of ordinary skill in the art will readily appreciate that certain cationic polymers include corresponding counter anions associated with the cationic monomer units (e.g., chloride ions as in poly(methacryloyloxyethyltrimethylammonium) chloride or poly(diallyldimethylammonium) chloride). While such counter anions may influence the functionality of the polymer, it will be understood that for the purposes of this disclosure the molecular weight of such counter anions is not included in the calculation of the charge density. In other words the charge density is computed without considering the molecular weight of any counter anion (if present). For example, for poly(diallyldimethylammonium) chloride the molecular weight of the diallyldimethylammonium monomer is about 126.1 such that the charge density is understood to be about 7.93 using Equation 1.

In certain cationic polymers (or terpolymers, etc.), the molar ratio of the monomers is unknown (i.e., at least one of $n_1$, $n_2$, ... $n_x$ are unknown in Equation 2). The charge density of such cationic polymers may be determined via measurement using a potassium polyvinylsulfate salt (PVSK) titration with a toluidine blue dye that is sensitive to the ionic character of the solution. In such measurements, the PVSK solution is titrated into an aqueous cationic polymer solution containing the blue dye until endpoint. In such a titration the solution starts dark blue and turns pink in the presence of excess PVSK (i.e., when all cationic polymer in solution is bound to the PVSK). Those of ordinary skill will readily appreciate that the color change (to pink) marks the end of the titration. The volume of PVSK titrant is recorded and used to compute the charge density of the polymer. The titration is preferably performed in triplicate to ensure suitable accuracy. The PVSK titration is described in more detail in Example 7.

For the purposes of this disclosure the titration of the cationic polymer having an unknown structure is compared with an identical titration conducted for a polymer having a known structure (Polyquaternium-7 is preferred). A first volume (or mass) of PVSK titrant $V_1$ is obtained when titrating the solution containing the cationic polymer having the known structure (Polyquaternium-7). A second volume (or mass) of PVSK titrant $V_2$ is obtained when titrating the solution containing the cationic polymer having an unknown structure. A relative charge density (e.g., relative to Polyquaternium-7) $CD_R$ is defined as the ratio of the titrant volumes (or masses) as follows:

$$CD_R = \frac{V_2}{V_1} \qquad (3)$$

A measured charge density of the cationic polymer having an unknown structure ($CD_2$) is taken to be the product of the relative charge density $CD_R$ and the computed charge density of the cationic polymer having the known structure (Polyquaternium-7) as follows:

$$CD_2 = CD_R \cdot CD_1 = \frac{V_2}{V_1} \cdot CD_1 \qquad (4)$$

where $CD_1$ represents the compute charge density of the cationic polymer having the known structure.

The PVSK titration is described in more detail in Example 7. Moreover, the above described procedure for determining relative charge density and the charge density of a cationic polymer having an unknown structure is described in further detail for numerous cationic polymers in Example 7.

The first group of disclosed compositions may include a cationic polymer having a charge density of greater than about 6 meq/g (e.g., greater than about 7 meq/g, greater than about 8 meq/g, or greater than about 9 meq/g).

Example high charge density cationic polymers include poly(vinylimidazole), poly(vinylimidazolium), poly(vinylmethyl imidazolium) such as poly(vinylmethyl imidazolium) and poly(vinylmethyl imidazolium) methyl sulfate, epichlorhydrin-dimethylamine, polydiallyldimethylammonium (e.g., polyDADMAC), polyethylenimine, polyarginine, polyhistidine, and ε-polylysine. In certain embodiments, a high charge density cationic polymer may include poly(vinylimidazolium) or ε-polylysine. Table 1 lists the charge density (meq/g) of each of the above listed cationic polymers using the Equations 1 and/or 2.

**Table 1**

| Cationic Polymer | Computed Charge Density |
|---|---|
| poly(vinylimidazole) | 12.5 |
| poly(vinylmethyl imidazolium) | 9.2 |
| epichlorhydrin-dimethylamine | 9.8 |
| polydiallyldimethylammonium | 7.9 |
| Polyethylenimine | 23.2 |
| polyarginine | 6.4 |
| Polyhistidine | 14.6 |

(continued)

| Cationic Polymer | Computed Charge Density |
|---|---|
| ε-polylysine | 7.8 |

Polishing compositions including a high charge density cationic polymer generally include a low concentration of the high charge density cationic polymer at point of use. For example, the polishing composition may include less than about 50 ppm by weight of the high charge density cationic polymer at point of use (e.g., less than about 25 ppm by weight, less than about 20 ppm by weight, less than about 15 ppm by weight, less than about 12 ppm by weight, or less than about 10 ppm by weight). Such polishing compositions may include greater than about 0.1 ppm by weight of the high charge density cationic polymer at point of use (e.g., greater than about 0.2 ppm by weight, greater than about 0.5 ppm by weight, greater than about 0.8 ppm by weight, or greater than about 1 ppm by weight). It will be understood that the high charge density cationic polymer may be present in the polishing composition at a concentration bounded by any two of the aforementioned endpoints. For example, polishing composition may include from about 0.1 ppm by weight to about 50 ppm by weight of the high charge density cationic polymer at point of use (e.g., from about 0.5 ppm by weight to about 25 ppm by weight, from about 1 ppm by weight to about 20 ppm by weight, or from about 1 ppm by weight to about 15 ppm by weight).

Polishing compositions including a high charge density cationic polymer may further include a silicon oxide polishing rate enhancer (i.e., a compound that that increases the removal rate of silicon oxide (such as TEOS or HDP)). Suitable polishing rate enhancers may include, for example, a carboxylic acid compound that activates the substrate. Example rate enhancers include, for example, picolinic acid, nicotinic acid, quinaldic acid, iso-nicotinic acid, acetic acid, and 4-hydroxybenzoic acid. In certain advantageous embodiments (and certain example embodiments disclosed below), the rate enhancer includes picolinic acid, acetic acid, or a mixture thereof.

While the disclosed embodiments are not limited in this regard, the first group of disclosed polishing compositions may be particularly well suited for CMP applications in which high silicon oxide removal rates are desirable. For example only, the first group of disclosed polishing compositions may be advantageously utilized in bulk oxide CMP applications in which a high silicon oxide removal rate is important and silicon oxide removal rate selectivity (e.g., to silicon nitride and/or polysilicon) is less important (or not important at all).

In a second group of the disclosed polishing compositions, the cationic polymer may be characterized as having a low charge density. For example, the second group of disclosed compositions may include a cationic polymer having a charge density of less than about 6 meq/g (e.g., less than about 5 meq/g, less than about 4 meq/g, or less than about 3 meq/g).

Example low charge density cationic polymers include, polyquaternium-69, vinyl caprolactam/vp/dimethylaminoethyl methacrylate copolymer, polyquaternium-46, poly(diallyldimethylammonium-co-N-vinyl pyrrolidone), polyquaternium-28, polyquaternium-44, polyquaternium-11, polyquaternium-68, polyquaternium-39, acrylamidopropyltrimonium chloride/acrylamide copolymer, polyquaternium-16, polyquaternium-7, succinylated epsilon polylysine, and poly(methacryloyloxyethyltrimethylammonium) (polyMADQUAT). In certain embodiments the low charge density cationic polymer may include polyquaternium-7, succinylated epsilon polylysine, polyMADQUAT, or a mixture thereof. Charge densities (meq/g) of each of the above listed cationic polymers are listed in Example 7.

Polishing compositions including a low charge density cationic polymer generally include a relatively higher concentration of the low charge density cationic polymer at point of use. For example, the polishing composition may include greater than about 10 ppm by weight of the low charge density cationic polymer at point of use (e.g., greater than about 15 ppm by weight, greater than about 20 ppm by weight, greater than about 25 ppm by weight, or greater than about 30 ppm by weight). Such polishing compositions may include less than about 500 ppm by weight of the low charge density cationic polymer at point of use (e.g., less than about 400 ppm by weight, less than about 300 ppm by weight, less than about 250 ppm by weight, or less than about 200 ppm by weight). It will be understood that the low charge density cationic polymer may be present in the polishing composition at a concentration bounded by any two of the aforementioned endpoints. For example, the polishing composition may include from about 10 ppm by weight to about 500 ppm by weight of the low charge density cationic polymer at point of use (e.g., from about 10 ppm by weight to about 300 ppm by weight, from about 15 ppm by weight to about 300 ppm by weight, or from about 20 ppm by weight to about 200 ppm by weight).

It will be understood that the preferred concentration of low charge density cationic polymer tends to be inversely proportional to the charge density of the polymer. For compositions employing a cationic polymer (or polymers) having a charge density in a range from about 3 meq/g to about 6 meq/g, the preferred concentration may be in a range from about 10 ppm by weight to about 100 ppm by weight at point of use (e.g., from about 20 ppm by weight to about 80 ppm by weight). For compositions employing a cationic polymer (or polymers) having a charge density of less than about 3 meq/g, the preferred concentration may be significantly higher, for example, in a range from about 30 ppm by weight to about 500 ppm by weight at point of use (e.g., from about 50 ppm by weight to about 300 ppm by weight).

Polishing compositions including a low density cationic polymer may further include a silicon oxide polishing rate enhancer (i.e., a compound that that increases the removal rate of silicon oxide (such as TEOS or HDP)). Suitable polishing rate enhancers may include, for example, a carboxylic acid compound that activates the substrate. Example rate enhancers include, for example, picolinic acid, nicotinic acid, quinaldic acid, iso-nicotinic acid, acetic acid, and 4-hydroxybenzoic acid. In certain advantageous embodiments (and certain of the example embodiments disclosed below), the rate enhancer includes picolinic acid, acetic acid, or a mixture thereof.

Polishing compositions including a low charge density cationic polymer may still further include a silicon nitride removal rate inhibitor (e.g., silicon nitride stopping agent), for example, including an unsaturated carboxylic acid such as an unsaturated monoacid. Suitable unsaturated monoacids may include, for example, acrylic acid, 2-butenoic acid (crotonic acid), 2-pentenoic acid, trans-2-hexenoic acid, trans-3-hexenoic acid, 2-hexynoic acid, 2,4-hexadienoic acid, potassium sorbate, trans-2-methyl-2-butenoic acid, 3,3-dimethylacrylic acid, or a combination thereof, including stereoisomers thereof. In the example embodiments disclosed below, the silicon nitride removal rate inhibitor is crotonic acid.

Polishing compositions including a low charge density cationic polymer may yet further include a nonionic additive such as a nonionic polymer. The nonionic additive may be, for example, a dispersant, a rheology agent, a polishing rate accelerator, a polishing rate inhibitor, or a selectivity promoter (to improve the removal rate ratio of one material to another). Suitable nonionic compounds may include water soluble nonionic polymers and non-polymeric nonionic compounds. The nonionic compounds may include water-soluble polyethers, polyether glycols, alcohol ethoxylates, polyoxyalkylene alkyl ethers, polyesters, vinylacrylates, and combinations thereof.

Nonionic polymers may be homopolymers or copolymers and may include substantially any suitable nonionic monomer units. Example nonionic polymers include polyvinyl acetate, polyvinyl alcohol, polyvinyl acetal, polyvinyl formal, polyvinyl butyral, polyvinylpyrrolidone, poly(vinyl phenyl ketone), poly(vinylpyridine), poly(acrylamide), polyacrolein, poly(methyl methacrylic acid), polyethylene, polyoxyethylene lauryl ether, polyhydroxyethylmethacrylate, poly(ethylene glycol) monolaurate, poly(ethylene glycol) monooleate, poly(ethylene glycol) distearate, and copolymers that include one or more of the aforementioned monomer units. Example copolymers include poly(vinyl acetate-co-methyl methacrylate), poly(vinylpyrrolidone-co-vinyl acetate), poly(ethylene-co-vinyl acetate). Certain of the example embodiments disclosed below include a poly(vinylpyrrolidone) nonionic polymer additive.

While the disclosed embodiments are not limited in this regard, the second group of disclosed polishing compositions may be particularly well suited for CMP applications in which a high silicon oxide removal rate is desirable but in which good topography (such as low dishing and erosion) and/or high selectivity to silicon nitride and/or polysilicon is also desirable. In such applications high silicon oxide removal rate is preferably balanced with good topography performance and high selectivity.

It will be understood that the disclosed polishing compositions (e.g., those in the first group of polishing compositions and/or those in the second group of polishing compositions) may further include substantially any other optional additives, for example including, secondary polishing rate accelerators or inhibitors, dispersants, conditioners, scale inhibitors, chelating agents, stabilizers, pH buffering agents, and biocides. Such additives are purely optional. The disclosed embodiments are not so limited and do not require the use of any one or more of such additives.

For example, the disclosed polishing compositions may optionally include a biocide. The biocide may include substantially any suitable biocide, for example an isothiazolinone biocide such as a methylisothiazolinone or a benzisothiazolone. The amount of biocide in the polishing composition at point of use is typically in a range from about 1 ppm by weight to about 100 ppm by weight at point of use, for example from about 5 ppm by weight to about 75 ppm by weight.

The polishing composition may be prepared using any suitable techniques, many of which are known to those skilled in the art. The polishing composition may be prepared in a batch or continuous process. Generally, the polishing composition may be prepared by combining the components thereof in any order. The term "component" as used herein includes the individual ingredients (e.g., the abrasive particles, the cationic polymer, and any optional additives). For example, the cationic polymer may be added to the aqueous carrier (e.g., water) at the desired concentration. The pH may then be adjusted (as desired) and the cubiform ceria abrasive added at the desired concentration to obtain the polishing composition. The polishing composition may be prepared prior to use, with one or more components added to the polishing composition just before use (e.g., within about 1 minute before use, or within about 1 hour before use, or within about 1 or about 7 days before use). The polishing composition also may also be prepared by mixing the components at the surface of the substrate during the polishing operation (e.g., on the polishing pad).

In certain embodiments, the polishing composition may be provided as a "two-pack" system. For example, a first pack may include the cubiform ceria abrasive particles and other optional components and a second pack may include the cationic polymer and other optional components. The first and second packs may be shipped separately and combined prior to polishing (e.g., within one hour or one day of polishing) or on the polishing pad during the CMP operation.

The polishing composition of the invention may be provided as a concentrate which is intended to be diluted with an appropriate amount of water prior to use. In such an embodiment, the polishing composition concentrate may include the cubiform ceria abrasive particles and other components described above in amounts such that, upon dilution of the concentrate with an appropriate amount of water each component of the polishing composition will be present in the polishing composition in an amount within the appropriate range recited above for each component. For example, the cubiform ceria abrasive particles, the cationic polymer, and other optional additives may each be present in the polishing composition in an amount that is about 3 times (e.g., about 4 times, about 5 times, about 6 times, about 7 times, about 8 times, about 10 times, about 15 times, about 20 times, or about 25 times) greater than the point of use concentration recited above for each component so that, when the concentrate is diluted with an equal volume of water (e.g., 2 equal volumes of water, 3 equal volumes of water, 4 equal volumes of water, 5 equal volumes of water, 6 equal volumes of water, 7 equal volumes of water, 9 equal volumes of water, 14 equal volumes of water, 19 equal volumes of water, or 24 equal volumes of water), each component will be present in the polishing composition in an amount within the ranges set forth above for each component.

In embodiments in which the polishing composition is provided as a two-pack system, either or both of the packs may be provided as a concentrate and require dilution prior to mixing with the other pack. For example, in one embodiment, the first pack is provided as a concentrate such that it includes cubiform ceria abrasive particles at a concentration that is about 3 times (e.g., about 5 times, about 8 times, about 10 times, about 15 times, or about 20 times) greater than the point of use concentrations recited above. The concentrated first pack may be mixed with a suitable quantity of water prior to combining with the second pack. Likewise, the second pack may be provided as a concentrate such that it includes cationic polymer concentrations that are about 3 times (e.g., about 5 times, about 8 times, about 10 times, about 15 times, or about 20 times) greater than the point of use concentrations recited above. In such embodiments, the concentrated second pack may be mixed with a suitable quantity of water prior to combining with the first pack. In certain embodiments, both the first and second packs may be diluted with water prior to combining. The disclosed embodiments are not limited in these regards.

The polishing method of the invention is particularly suited for use in conjunction with a chemical mechanical polishing (CMP) apparatus, for example including a platen and a pad affixed thereto. As is known to those of ordinary skill in the art, polishing of the substrate takes place when the substrate is placed in contact with the polishing pad and the polishing composition of the invention and then the polishing pad and the substrate move relative to one another so as to abrade at least a portion of the substrate. The inventive method includes providing the inventive composition described above, contacting a substrate (e.g., a wafer) with the inventive composition, moving the polishing composition relative to the substrate, and abrading the substrate to remove a portion of a silicon oxide material from the substrate and thereby polish the substrate.

The substrate generally includes a silicon oxide dielectric layer, many of which are well known. For example, the silicon oxide layer may comprise, consist of, or consist essentially of any one or more of: tetraethoxysilane (TEOS), high density plasma (HDP) oxide, phosphosilicate glass (PSG), borophosphosilicate glass (BPSG), high aspect ratio process (HARP) oxide, spin on dielectric (SOD) oxide, chemical vapor deposition (CVD) oxide, plasma-enhanced tetraethyl ortho silicate (PETEOS), thermal oxide, or undoped silicate glass.

The polishing composition desirably exhibits a high removal rate when polishing a substrate including a silicon oxide material. For example, when polishing silicon wafers comprising high density plasma (HDP) oxides and/or plasma-enhanced tetraethyl ortho silicate (PETEOS), spin-on-glass (SOG), and/or tetraethyl orthosilicate (TEOS), the polishing composition desirably exhibits a silicon oxide removal rate of about 2000 Å/min or higher (e.g., about 4000 Å/min or higher, about 5000 Å/min or higher, or about 6,000 Å/min or higher). In certain embodiments (e.g., when using the first group of polishing compositions), the polishing composition desirably exhibits a very high silicon oxide removal rate (e.g., 6,000 Å/min or higher, 7,000 Å/min or higher, 8,000 Å/min or higher, or even 9,000 Å/min or higher).

In certain embodiments (e.g., when using the second group of polishing compositions), the polishing composition may advantageously exhibit both high silicon oxide removal rates and selectivity to silicon nitride and/or polysilicon. In such embodiments, the silicon oxide removal rate may be 3000 Å/min or higher (e.g., about 4000 Å/min or higher, or about 5000 Å/min or higher) and the silicon oxide to silicon nitride and/or silicon oxide to polysilicon selectivity may be at least 20 to 1 (e.g., at least 40 to 1, at least 60 to 1, at least 80 to 1, or even at least 100 to 1).

The second group of polishing compositions may further desirably exhibit low dishing and erosion when polishing a substrate having a patterned silicon oxide layer. For example, when polishing patterned wafers including a silicon oxide material filled over polysilicon trenches, the polishing composition desirably exhibits erosion and dishing of less than about 200 Å (e.g., less than about 150 Å, less than about 100 Å, less than about 75 Å, or less than about 50 Å). Moreover, the polishing composition and method desirably achieve such erosion and dishing levels over a wide range line widths and pattern densities, for example, line widths ranging from 0.5 μm to 100 μm and pattern densities ranging from 10 percent to 90 percent.

It will be understood that the disclosure includes numerous embodiments.

The following examples further illustrate the invention but, of course, should not be construed as in any way limiting its scope. Various substrates were polished using an Applied Materials Mirra® polishing tool (available from Applied Materials, Inc.). Blanket wafers were polished for 60 seconds on the Mirra® at a platen speed of 100 rpm, a head speed of 85 rpm, a downforce of 3 psi, and a slurry flow rate of 150 ml/min. The wafers were polished on a NexPlanar® E6088 pad (available from Cabot Microelectronics Corporation) with *in-situ* conditioning using a Saesol DS8051 conditioner at 6 pounds downforce.

Blanket tetraethylorthosilicate (TEOS), high density plasma (HDP) oxide, SiN-PE wafers, and polysilicon wafers were polished in the Examples that follow. The TEOS wafers were obtained from WRS Materials and included a 20 kÅ TEOS layer. The HDP wafers were obtained from Silyb and included a 10 kÅ HDP oxide layer. The SiN-PE wafers were obtained from Advantec and included a 5 kÅ PE SiN layer. The polysilicon wafers were obtained from WRS Materials and included a 10 kÅ polySi layer. The patterned HDP wafers were obtained from Silyb and included STI1 4 kÅ HDP oxide with a 2 kÅ underlayer of polysilicon.

EXAMPLE 1

A stock cerium oxide dispersion was prepared as follows. A cerium nitrate solution was prepared by combining 13.1 kg of a 3 M trivalent cerium(III) nitrate solution, 0.3 kg of a 3 M lanthanum nitrate solution, 2.0 kg of a 68% nitric acid ($HNO_3$) solution, 0.5 kg deionized water, and cerium(IV) nitrate at a molar ratio of cerium(IV) to cerium(total) equal to 0.000055. The cerium nitrate solution was then degassed with agitation and nitrogen bubbling in a 20 L vessel.

An aqueous ammonia solution was prepared by combining 75 kg of deionized water and a solution of 13.1 kg of 25% aqueous ammonia (such that the molar ratio of $NH_4OH$ in the aqueous ammonia solution to the total cerium and lanthanum in the cerium nitrate solution was 9.0). The aqueous ammonia solution was then degassed with agitation and nitrogen bubbling in a 100 L vessel jacketed reactor.

The cerium nitrate solution was then added, at ambient temperature, to the aqueous ammonia solution with the same agitation under nitrogen purging. The temperature of the reaction mixture was then increased to 80° C and held at that temperature for 18 hours. The reaction mixture was then left to cool and upon cooling was acidified to pH 2 by adding 68% nitric acid.

The reaction mixture was then filtrated and washed with deionized water. The washing was repeated when the conductivity of the washing solution was less than 0.04 mS/cm. Deionized water was added to adjust the final cerium oxide concentration to 10 weight percent. The cubiform ceria abrasive particles included 2.5 mole percent lanthanum oxide and 97.5 mole percent cerium oxide.

The BET specific surface area was determined by nitrogen adsorption to be 11.8 $m^2$ per gram. The average particle size was 102 nm as measured by Horiba 960 and 140 nm as measured by the Malvern Zetasizer.

EXAMPLE 2

Six polishing compositions were tested to evaluate the effect of poly(vinylimidazolium) methyl sulfate (PVI) and acetic acid on the TEOS polishing rate. The compositions included different levels of PVI as follows: no PVI (2A,) 1 ppm by weight (2B, 2E, and 2F), 2ppm by weight (2C), and 4 ppm by weight (2D). Compositions 2E and 2F further included 50 ppm by weight acetic acid (2E) and 500 ppm by weight acetic acid (2F). Each composition further included 500 ppm by weight picolinic acid and was prepared using the stock ceria dispersion described above in Example 1. The polishing compositions were prepared by first adding appropriate quantities of picolinic acid, acetic acid, and PVI to deionized water. An appropriate quantity of the Example 1 stock ceria dispersion was then added such that each composition included 0.2 weight percent cubiform ceria abrasive particles. The pH of each composition was about 4.

Blanket TEOS wafers were polished for 60 seconds on a Mirra® tool at the conditions listed above. Polishing results are shown in Table 2. All removal rates (RR) are listed in angstroms per minute (Å/min).

Table 2

| Composition | PVI (ppm) | Acetic (ppm) | TEOS RR |
|---|---|---|---|
| 2A | 0 | 0 | 5907 |
| 2B | 1 | 0 | 6176 |
| 2C | 2 | 0 | 6678 |
| 2D | 4 | 0 | 7042 |
| 2E | 1 | 50 | 6246 |
| 2F | 1 | 500 | 5914 |

It is readily apparent from the results set forth in Table 2, that the TEOS removal rate increases with increasing PVI concentration (comparing compositions 2A, 2B, 2C, and 2D). This is the opposite of what is generally observed for conventional wet ceria. It is further apparent that the removal rate is not strongly influenced by acetic acid, particularly at lower concentrations such as 50 ppm by weight (comparing compositions 2A, 2E, and 2F).

EXAMPLE 3

Three polishing compositions were tested to evaluate the effect of cationic polyvinylalcohol (cat PVOH) on the TEOS polishing rate. Composition 3A was identical to composition 2A. The compositions included different levels of cat PVOH as follows: no cat PVOH (3A), 1 ppm by weight (3B), and 5 ppm by weight (3C). Each composition further included 500 ppm by weight picolinic acid and was prepared using the stock ceria dispersion described above in Example 1. The polishing compositions were prepared by first adding appropriate quantities of picolinic acid and GOHSENX K-434 (cationic PVOH available from Mitsubishi Chemical) to deionized water. An appropriate quantity of the Example 1 stock ceria dispersion was then added such that each composition included 0.2 weight percent cerium oxide. The pH of each composition was about 4.

Blanket TEOS wafers were polished for 60 seconds on a Mirra® tool at the conditions listed above. Polishing results are shown in Table 3. All removal rates (RR) are listed in angstroms per minute (Å/min).

Table 3

| Composition | PVOH (ppm) | TEOS RR |
|---|---|---|
| 3A | 0 | 5907 |
| 3B | 1 | 5891 |
| 3C | 5 | 6115 |

As is readily apparent from the results set forth in Table 3, at low levels (1 ppm), cat PVOH has little to no influence on the TEOS removal rates. At higher levels (5 ppm) cat PVOH moderately increases TEOS removal rates.

EXAMPLE 4

Two polishing compositions were tested. Composition 4A was identical to composition 2A. Composition 4B included 0.017 weight percent maltol, 0.25 weight percent Emulgen A-500 (a polyoxyethylene distyrenated phenyl ether available from KAO Global Chemicals), 0.75 ppm by weight PAS-J-81 (an acrylamide copolymer of polyDADMAC trademarked by Nitto Boseki Co.), and 0.023 weight percent propanoic acid. Each composition was prepared using the stock ceria dispersion described above in Example 1 and included 0.2 weight percent cerium oxide. The pH of each composition was about 4.0.

Blanket TEOS and polysilicon wafers were polished for 60 seconds on a Mirra® tool at the conditions listed above. Polishing results are shown in Table 4. All removal rates (RR) are listed in angstroms per minute (Å/min).

Table 4

| Composition | TEOS RR | Poly RR | TEOS:Poly |
|---|---|---|---|
| 4A | 5907 | 858 | 7 |
| 4B | 5382 | 31 | 174 |

As is readily apparent from the results set forth in Table 4, composition 4B including the cationic polymer, exhibited a similar TEOS removal rate and vastly superior selectivity to polysilicon.

EXAMPLE 5

Twelve polishing compositions were tested to evaluate the effect of cationic polymer loading on TEOS removal rates. Compositions 5A-5L were prepared by combining a first pack (the A pack) with deionized water and a corresponding second pack (the B pack). The A pack included 1000 ppm by weight picolinic acid, 300 ppm by weight Kordek MLX biocide available from DuPont, and 2 weight percent ceria abrasive particles. For compositions 5A-5D, a wet-process ceria (HC60™ commercially available from Rhodia) was used as a first control ceria and was combined with deionized water, picolinic acid and Kordex MLX. For compositions 5E-5H a sintered ceria (the ceria abrasive used in polishing composition 1C of commonly assigned U.S. Patent 9,505,952) was used as a second control ceria and was combined with deionized water, picolinic acid and Kordex MLX. For compositions 5I-5L the stock ceria dispersion described in Example 1 was combined with deionized water, picolinic acid and Kordex MLX. The pH value of each A pack was about 4.

The B packs included 500 ppm by weight polyvinylpyrrolidone (PVP) (having a molecular weight of 5000 g/mol), 2250 ppm by weight acetic acid, 3413 ppm by weight crotonic acid, 150 ppm by weight Kordek MLX. biocide, and cationic polymer. For compositions 5A, 5E, and 5I the cationic polymer included 100 ppm by weight Polyquaternium-7. For compositions 5B, 5F, and 5J the cationic polymer included 200 ppm by weight Polyquaternium-7. For compositions 5C, 5G, and 5K the cationic polymer included 100 ppm by weight polyMADQUAT. For compositions 5D, 5H, and 5L the cationic polymer included 200 ppm by weight polyMADQUAT. The pH of the B pack was about 4.

One part of the A pack was first combined with 6 parts deionized water and then further combined with 3 parts of the B pack to obtain point of use compositions that included 0.2 weight percent ceria abrasive and either 30 or 60 weight percent cationic polymer. The point of use pH was about 4 for each composition.

Blanket TEOS wafers were polished for 60 seconds on a Mirra® tool at the conditions listed above. Polishing results are shown in Table 5. All removal rates (RR) are listed in angstroms per minute (Å/min).

Table 5

| Composition | Ceria Abrasive | Cationic Polymer | TEOS RR |
|---|---|---|---|
| 5A | First Control | 30 ppm Polyquaternium-7 | 2874 |
| 5B | First Control | 60 ppm Polyquaternium-7 | 31 |
| 5C | First Control | 30 ppm polyMADQUAT | 2870 |
| 5D | First Control | 60 ppm polyMADQUAT | 21 |
| 5E | Second Control | 30 ppm Polyquaternium-7 | 5796 |
| 5F | Second Control | 60 ppm Polyquaternium-7 | 26 |
| 5G | Second Control | 30 ppm polyMADQUAT | 5832 |
| 5H | Second Control | 60 ppm polyMADQUAT | 25 |
| 5I | Cubiform | 30 ppm Polyquaternium-7 | 6880 |
| 5J | Cubiform | 60 ppm Polyquaternium-7 | 5839 |
| 5K | Cubiform | 30 ppm polyMADQUAT | 6846 |
| 5L | Cubiform | 60 ppm polyMADQUAT | 4702 |

As is readily apparent from the results set forth in Table 5 compositions 5H-5L including the cubiform ceria abrasive particles exhibited superior removal rates as compared to the control ceria compositions. Moreover, compositions 5I and 5K, including 60 ppm by weight cationic polymer and cubiform ceria abrasive particles exhibited high removal rates. The analogous control ceria compositions 5B, 5D, 5F, and 5H exhibited no appreciable removal rate at 60 ppm by weight cationic polymer.

EXAMPLE 6

Four polishing compositions were tested to evaluate the effect of cationic polymer loading on TEOS removal rates and dishing. Compositions 6A-6D were prepared by combining an A pack with deionized water and a corresponding B pack as described above in Example 5. The A pack included 1000 ppm by weight picolinic acid, 300 ppm by weight Kordek MLX. biocide available from DuPont, and 2 weight percent ceria abrasive particles. For composition 6A the A pack included the first control ceria described above with respect to compositions 5A-5D. For compositions 6B-6D the ceria abrasive particles in the A pack were obtained by combining 1 part of the stock ceria dispersion described in Example 1 with 4 parts deionized water. The pH of the A pack was about 4.

The B pack included PVP (5000 g/mol) (333 ppm by weight for compositions 6A, 6B, and 6C and 500 ppm by weight for composition 6D), 2250 ppm by weight acetic acid, 3413 ppm by weight crotonic acid, 150 ppm by weight Kordek MLX biocide, and Polyquaternium-7 (125 ppm by weight for compositions 6A, 140 ppm by weight for composition 6B, and 200 ppm by weight for compositions 6C and 6D). The pH of the B pack was about 4.

One part of the A pack was first combined with 6 parts deionized water and then further combined with 3 parts of the B pack to obtain point of use compositions that included 0.2 weight percent ceria abrasive and 37.5 ppm by weight (6A), 42 ppm by weight (6B), or 60 ppm by weight (6C and 6D) of the Polyquaternium-7.

Blanket TEOS wafers were polished for 60 seconds and patterned HDP wafers were polished to 100% overpolish on a Mirra® tool at the conditions listed above. Polishing results are shown in Table 6. All removal rates are listed in angstroms per minute (Å/min). Dishing is in units of angstroms (Å).

Table 6

| Composition | Ceria | Polyquaternium-7 | TEOS RR | Dishing | RR:Dishing |
|---|---|---|---|---|---|
| 6A | First Control | 37.5 | 2051 | 92 | 22 |
| 6B | Cubiform | 42 | 5977 | 484 | 12 |
| 6C | Cubiform | 60 | 4817 | 194 | 25 |
| 6D | Cubiform | 60 | 4667 | 136 | 34 |

As is readily apparent from the results set forth in Table 6, compositions 6B-6D exhibit significantly improved TEOS removal rate as compared to the control composition 6A (over 2x improvement). Moreover, compositions 6C and 6D (particularly 6D) exhibit superior removal rate to dishing ratios.

EXAMPLE 7

Forty-five polishing compositions were tested to evaluate the effect of charge density on the TEOS removal rate. Each of the compositions was prepared by combining an A pack with deionized water and a corresponding B pack as described above in Example 5. The A pack included 20 weight percent of the stock ceria dispersion prepared in Example 1, 1750 ppm by weight picolinic acid, and 75 ppm by weight Kordek MLX. biocide. The remainder was deionized water.

The B pack included 333 ppm by weight PVP (5000 g/mol), 2250 ppm by weight acetic acid, 1707 ppm by weight crotonic acid, 500 ppm by weight Kordek MLX, and 100 ppm by weight, 300 ppm by weight, or 500 ppm by weight of a cationic polymer. The cationic polymers included Aquastyle 300AF (Polyquaternium-69 available from Ashland Chemical) (7A), Advantage S (Vinyl Caprolactam/VP/Dimethylaminoethyl Methacrylate Copolymer available from Ashland Chemical) (7B), Luviquat Hold (Polyquaternium-46 available from BASF) (7C), poly(diallyldimethylammonium) chloride-co-N-vinyl pyrrolidone with a DADMAC:NVP ratio of 9:91 (referred to as DADNPV-9:91) (7D), Gafquat HS-100 (Polyquaternium-28 available from Ashland Chemical) (7E), Luviquat Ultra (Polyquaternium-44 available from BASF) (7F), Luviquat PQ 11 (Polyquaternium-11 available from BASF) (7G), Luviquat Supreme (Polyquaternium-68 available from BASF) (7H), Merquat 3940 (Polyquaternium-39 available from Lubrizol) (7I), N-Hance SP 100 (Acrylamidopropyltrimonium Chloride/Acrylamide Copolymer available from Ashland Chemical) (7J), Luviquat FC 370 (Polyquaternium-16 available from BASF) (7K), poly(diallyldimethylammonium) chloride-co-N-vinyl pyrrolidone with a DADMAC:NVP ratio of 28:72 (referred to as DADNPV-28:72) (7L), Polyquaternium-7 (7M), poly(diallyldimethylammonium) chloride-co-N-vinyl pyrrolidone with a DADMAC:NVP ratio of 70:30 (referred to as DADNPV-70:30) (7N), or polyMADQUAT (7O).

The charge densities of the listed cationic polymers having a known structure were calculated as described above with respect to Equations 1 and 2. The relative charge density (relative to Polyquaternium-7) of each listed cationic polymer was determined via PVSK titration as described above and in more detail below. The charge densities of the listed cationic polymers having an unknown structure were calculated as the products of the relative charge density and the calculated charge density of Polyquaternium-7. These charge density (CD) values are listed in Table 7A.

The PVSK titration procedure used to determine the relative charge density values listed in Table 7A was as follows: Aqueous solutions of each cationic polymer were prepared by mixing the cationic polymer in deionized water. The concentration of each aqueous cationic polymer solution was 68 ppm cationic polymer. A dilute PVSK solution was prepared by diluting 1 part by weight potassium polyvinyl sulfate N/400 (available from Wako Chemicals) with 1.5 parts by weight deionized water (a 2.5X dilution). A dilute toluidine blue-O solution was prepared by diluting 0.1 gram toluidine blue-O (available from Sigma Aldrich) with 99.9 grams deionized water to obtain 100 grams of the dilute toluidine blue-O solution (0.1 percent toluidine blue-O).

Blue cationic polymer solutions were obtained by adding 105 $\mu$L (about 2 drops) of the dilute toluidine blue-O solution to 25 grams of aqueous cationic polymer solution (68 ppm cationic polymer). The dilute PVSK solution was titrated into the blue cationic polymer solution until endpoint (i.e., until the color of the blue cationic polymer solution changed from blue to pink). The volume of dilute PVSK solution titrated was recorded. Each of the listed cationic polymers was tested three times. The average volume of titrated dilute PVSK solution was used to compute the relative charge density.

As described above, the Polyquaternium-7 cationic polymer was used as the standard. The relative charge density was computed as described above with respect to Equation 3 such that the average volume of titrant used for each cationic polymer was divided by the average volume of titrant used for Polyquaternium-7. The measured charge density was computed as described above with respect to Equation 4 by multiplying the relative charge density by the calculated charge density for Polyquaternium-7 (obtained from Equation 1 and the known structure of Polyquaternium-7).

**Table 7A**

| Composition | Cationic Polymer | CD (relative) | CD (measured) | CD (Calculated) |
|---|---|---|---|---|
| 7A | Polyquaternium-69 | 4% | 0.14 | |
| 7B | Vinyl Caprolactam/VP/ Dimethylaminoethyl Methacrylate Copolymer | 6% | 0.21 | |
| 7C | Polyquaternium-46 | 25% | 0.86 | 0.8 |
| 7D | DADNPV-9:91 | 27% | 0.93 | 0.9 |
| 7E | Polyquaternium-28 | 31% | 1.1 | |
| 7F | Polyquaternium-44 | 41% | 1.4 | 1.8 |
| 7G | Polyquaternium-11 | 45% | 1.5 | 2.5 |
| 7H | Polyquaternium-68 | 60% | 2.1 | 1.6 |
| 7I | Polyquaternium-39 | 69% | 2.4 | |
| 7J | Acrylamidopropyltrimonium Chloride/Acrylamide Copolymer | 72% | 2.5 | |
| 7K | Polyquaternium-16 | 92% | 3.1 | 2.7 |
| 7L | DADNPV-28:72 | 92% | 3.1 | 2.6 |
| 7M | Polyquaternium-7 | 100% | 3.4 | 3.4 |
| 7N | DADNPV-70:30 | 172% | 5.4 | 4.2 |
| 7O | PolyMADQUAT | 178% | 5.6 | 5.8 |

Prior to polishing, one part the above described A pack was first combined with 6 parts deionized water and then further combined with 3 parts of each of the B packs to obtain point of use compositions 7A through 7O that included 0.2 weight percent ceria abrasive and 30, 90, or 150 ppm by weight of the listed cationic polymers.

Blanket TEOS wafers were polished for 30 seconds on a Logitech polishing tool at the conditions listed above for the Mirra® tool. Polishing results are shown in Table 7B. All removal rates are listed in angstroms per minute (Å/min).

Table 7B

| Compositions | Cationic Polymer | TEOS Removal Rate (A/min) | | |
|---|---|---|---|---|
| | | 30 ppm | 90 ppm | 150 ppm |
| 7A | Polyquaternium-69 | 3641 | 3732 | 3722 |
| 7B | Vinyl Caprolactam/VP/ Dimethylaminoethyl Methacrylate Copolymer | 3571 | 3783 | 3725 |
| 7C | Polyquaternium-46 | 4319 | 4734 | 4260 |
| 7D | DADNPV-9:91 | 4974 | 4515 | 3955 |
| 7E | Polyquaternium-28 | 3866 | 4198 | 3528 |
| 7F | Polyquaternium-44 | 4299 | 4038 | 3209 |
| 7G | Polyquaternium-11 | 3839 | 3441 | 3375 |
| 7H | Polyquaternium-68 | 4026 | 3903 | 3564 |
| 7I | Polyquaternium-39 | 3568 | 2593 | 2010 |
| 7J | Acrylamidopropyltrimonium Chloride/Acrylamide Copolymer | 4078 | 3849 | 4518 |
| 7K | Polyquaternium-16 | 4797 | 646 | 52 |
| 7L | DADNPV-28:72 | 4327 | 122 | 65 |
| 7M | Polyquaternium-7 | 3552 | 1305 | 751 |

(continued)

| Compositions | Cationic Polymer | TEOS Removal Rate (A/min) | | |
|---|---|---|---|---|
| | | 30 ppm | 90 ppm | 150 ppm |
| 7N | DADNPV-70:30 | 175 | 63 | 40 |
| 7O | PolyMADQUAT | 1657 | 177 | 93 |

As is apparent from the results set forth in Table 7B, the TEOS removal rate may be influenced by both the cationic polymer loading and the cationic polymer charge density. At higher charge densities, the TEOS removal rate tends to decrease at higher cationic polymer loading levels. At lower charge densities, the TEOS removal rate is less dependent on cationic polymer loading levels (at least in the range from 30 ppm by weight to 150 ppm).

EXAMPLE 8

Four polishing compositions were tested to evaluate the effect of cationic polymer loading on TEOS removal rates and dishing. Compositions 8A-8D were prepared by combining an A pack with deionized water and a corresponding B pack as described above in Example 5. For compositions 8A and 8D the A pack included 1750 ppm by weight picolinic acid, 75 ppm by weight Kordek MLX, and 2 weight percent ceria abrasive particles. Composition 8A included the first control ceria described above in Example 5. Composition 8D included the stock ceria dispersion described above in Example 1. For compositions 8B and 8C, the A pack included 3500 ppm by weight picolinic acid, 75 ppm by weight Kordek MLX, and 2 weight percent of the second control ceria described above in Example 5.

The B pack for compositions 8A-8D included the following components:

(8A) 333 ppm by weight PVP (2500 g/mol), 2250 ppm by weight acetic acid, 417 ppm by weight crotonic acid, 125 ppm by weight Polyquaternium-7, and 150 ppm by weight Kordek MLX.
(8B) 667 ppm by weight polyethylene glycol octadecyl ether (Brij® S20), 1500 ppm by weight acetic acid, 117 ppm by weight Polyquaternium-7, and 150 ppm by weight Kordek MLX.
(8C) 667 ppm by weight Brij® S20, 1500 ppm by weight acetic acid, 833 ppm by weight crotonic acid, 133 ppm by weight Polyquaternium-7, and 150 ppm by weight Kordek MLX.
(8D) 333 ppm by weight PVP (2500 g/mol), 2250 ppm by weight acetic acid, 3413 ppm by weight crotonic acid, 200 ppm by weight Polyquaternium-7, and 150 ppm by weight Kordek MLX.

One part of the A pack was first combined with 6 parts deionized water and then further combined with 3 parts of the B pack to obtain point of use compositions that included 0.2 weight percent ceria abrasive, 37.5 ppm by weight (8A), 35 ppm by weight (8B), or 40 ppm by weight (8C), and 60 ppm by weight of the Polyquaternium-7, and 125 ppm by weight (8A), 0 ppm by weight (8B), 250 ppm by weight (8C), and 1000 ppm by weight (8D) crotonic acid.

Blanket TEOS wafers were polished for 60 seconds and patterned HDP wafers were polished to 100 percent overpolish on a Mirra® tool at the conditions listed above. Polishing results are shown in Table 8. All removal rates are listed in angstroms per minute (Å/min). Dishing is in units of angstroms (Å).

Table 8

| Composition | TEOS RR | Dishing | RR:Dishing |
|---|---|---|---|
| 8A | 3363 | 215 | 16 |
| 8B | 5091 | 351 | 15 |
| 8C | 354 | NA | NA |
| 8D | 5763 | 199 | 29 |

As is readily apparent from the results set forth in Table 8, composition 8D including the cubiform ceria abrasive particles achieves both higher a TEOS removal rate and an improved removal rate to dishing ratio. The cubiform ceria abrasive particles achieve much higher TEOS removal rates at higher cationic polymer concentrations thereby enabling the use of higher cationic polymers to reduce dishing (and improve the removal rate to dishing ratio).

EXAMPLE 9

Three polishing compositions were tested on an Applied Materials Reflexion® polishing tool. Compositions 9A-9C were prepared by combining an A pack with deionized water and a corresponding B pack as described above in Example 5. For each of the compositions the A pack included 1750 ppm by weight picolinic acid, 75 ppm by weight Kordek MLX, and 2 weight percent ceria obtained from the stock ceria dispersion described above in Example 1.

The B pack for compositions 9A-9C included the following components:

(9A) 500 ppm by weight PVP (9700 g/mol), 2250 ppm by weight acetic acid, 3413 ppm by weight crotonic acid, 500 ppm by weight Luviquat Polyquaternium 11 (see Example 7), and 150 ppm by weight Kordek MLX.
(9B) 500 ppm by weight PVP (9700 g/mol), 2250 ppm by weight acetic acid, 3413 ppm by weight crotonic acid, 150 ppm by weight Polyquaternium-7, and 150 ppm by weight Kordek MLX.
(9C) 500 ppm by weight PVP (9700 g/mol), 2250 ppm by weight acetic acid, 3413 ppm by weight crotonic acid, 100 ppm by weight polyDADMAC, and 150 ppm by weight Kordek MLX.

One part of the A pack was first combined with 6 parts deionized water and then further combined with 3 parts of the B pack to obtain point of use compositions that included 0.2 weight percent ceria abrasive, 150 ppm by weight (9A), 40 ppm by weight (9B), or 30 ppm by weight (8C) of cationic polymer.

Blanket TEOS wafers were polished for 60 seconds and patterned HDP wafers were polished to 100 percent overpolish on an Applied Materials Reflexion® tool and NexPlanar® E6088 polishing pad at a platen speed of 93 rpm, a head speed of 87 rpm, a downforce of 2 psi, and a slurry flow rate of 175 ml/min with *in situ* conditioning using a Saesol DS8051 conditioner at 6 pounds downforce. Polishing results are shown in Table 9. All removal rates are listed in angstroms per minute (Å/min). Dishing is in units of angstroms (Å).

Table 9

| Composition | TEOS RR | Dishing | RR:Dishing |
|---|---|---|---|
| 9A | 4691 | 483 | 10 |
| 9B | 4260 | 125 | 34 |
| 9C | 253 | NA | NA |

As is readily apparent from the results set forth in Table 9, composition 8A including the Luviquat PQ 11 cationic polymer achieves a high TEOS removal rate, composition 8B including the Polyquaternium-7 cationic polymer achieves both high TEOS removal rate and very low dishing, and composition 9C including the polyDADMAC cationic polymer had very low TEOS removal rates.

EXAMPLE 10

Ten polishing compositions were tested to evaluate the effect of crotonic acid on TEOS removal rate. Compositions 10A-10J were prepared by combining an A pack with deionized water and a corresponding B pack as described above in Example 5. For compositions 10A-10F the A pack included 1750 ppm by weight picolinic acid, 75 ppm by weight Kordex MLX. and 2 weight percent ceria. Compositions 10A-10D included the first control ceria described above in Example 5 while compositions 10E and 10F used the stock ceria dispersion described above in Example 1. For Compositions 10G-10J, the A pack included 3500 ppm by weight picolinic acid, 75 ppm by weight Kordex MLX and 2 weight percent of the second control ceria described above in Example 5.

The B packs for compositions 10A-10D and 10G-10J included 667 ppm by weight Brij® S20 (Example 8), 1500 ppm by weight acetic acid, and 500 ppm by weight Kordex MLX. The B packs of compositions 10A-10D further included 100 ppm by weight (10A and 10B) or 150 ppm by weight (10C and 10D) Polyquaternium-7. The B packs of compositions 10B and 10D still further included 833 ppm by weight crotonic acid.

The B packs of compositions 10G-10J further included 100 ppm by weight polyMADQUAT. The B packs of compositions 10H-10J still further included 427 ppm by weight (10H), 1493 ppm by weight (10I), and 5000 ppm by weight (10J) crotonic acid.

The B packs for compositions 10E and 10F included 333 ppm by weight PVP (2500 g/mol), 2167 ppm by weight acetic acid, 200 ppm by weight Polyquaternium-7, and 500 ppm by weight Kordek MLX. The B packs of compositions 10E and 10F further included 1389 ppm by weight (10E) and 5689 ppm by weight (10F) crotonic acid.

One part of the A pack was first combined with 6 parts deionized water and then further combined with 3 parts of the B pack to obtain point of use compositions that included 0.2 weight percent ceria abrasive. Blanket TEOS wafers were polished for 60 seconds on a Mirra® tool at the conditions listed above. Polishing results are shown in Table 10. All removal rates are listed in angstroms per minute (Å/min). The concentrations of cationic polymer and crotonic acid are listed in ppm by weight.

Table 10

| Composition | Ceria | Cationic Polymer | POU Polymer Concentration | POU Crotonic Acid | TEOS RR |
|---|---|---|---|---|---|
| 10A | First Control | Polyquaternium-7 | 30 | 0 | 2483 |
| 10B | First Control | Polyquaternium-7 | 30 | 250 | 2291 |
| 10C | First Control | Polyquaternium-7 | 45 | 0 | 1286 |
| 10D | First Control | Polyquaternium-7 | 45 | 250 | 1289 |
| 10E | Cubiform | Polyquaternium-7 | 60 | 417 | 5468 |
| 10F | Cubiform | Polyquaternium-7 | 60 | 1707 | 6216 |
| 10G | Second Control | PolyMADQUAT | 30 | 0 | 4730 |
| 10H | Second Control | PolyMADQUAT | 30 | 128 | 4645 |
| 10I | Second Control | PolyMADQUAT | 30 | 448 | 4454 |
| 10J | Second Control | PolyMADQUAT | 30 | 1500 | 2767 |

As is readily apparent from the results set forth in Table 10, the TEOS removal rate increases with crotonic acid concentration for compositions cubiform ceria abrasive particles (10E and 10F). The TEOS removal rate is essentially independent of crotonic acid concentration (at low concentrations) for compositions including the first control ceria (10A-10D). The TEOS removal rate decreases with increasing crotonic acid concentration for compositions including the second control ceria (10A-10D).

EXAMPLE 11

Three polishing compositions were tested to evaluate the effect of PVP molecular weight on TEOS removal rate and dishing. Compositions 11A-11C were prepared by combining an A pack with deionized water and a corresponding B pack as described above in Example 5. The A pack included 1000 ppm by weight picolinic acid, 75 ppm by weight Kordex MLX and 2 weight percent ceria and was prepared using the stock ceria solution described above in Example 1.

The B packs included 500 ppm by weight PVP, 2250 ppm by weight acetic acid, 3413 ppm by weight crotonic acid, 150 ppm by weight Polyquaternium-7, and 150 ppm by weight Kordex MLX. The PVP molecular weights were about 5000 g/mol (11A), 9700 g/mol (11B), and 66,800 g/mol (11C).

One part of the A pack was first combined with 6 parts deionized water and then further combined with 3 parts of the B pack to obtain point of use compositions that included 0.2 weight percent ceria abrasive.

Blanket TEOS wafers were polished for 60 seconds on a Mirra® tool at the conditions listed above. Pattern wafers were polished to 100 percent overpolish on a Reflexion® tool and NexPlanar® E6088 polishing pad at the conditions listed above in Example 9. Polishing data are shown in Table 11. All removal rates are listed in angstroms per minute (Å/min). Dishing is listed in angstroms (Å).

Table 11

| Composition | PVP MW | TEOS RR | Dishing |
|---|---|---|---|
| 11A | 5000 | 5885 | 167 |
| 11B | 9700 | 5551 | 263 |
| 11C | 40,000 | 4411 | |

As is readily apparent from the results set forth in Table 11, the highest removal rate and lowest dishing is achieved with composition 11A having a PVP molecular weight of about 5000 g/mol.

EXAMPLE 12

Six polishing compositions were tested to evaluate the effect of epsilon polylysine (ePLL) on TEOS removal rate. Compositions 12A-12F were prepared by combining an A pack with deionized water and a corresponding B pack as described above in Example 5. The A pack included 1000 ppm by weight picolinic acid, 300 ppm by weight Kordex MLX and 2 weight percent ceria. For compositions 12A and 12B, the A pack included the first control ceria described above in Example 5. For compositions 12C and 12D, the A pack included the second control ceria described above in Example 5. For compositions 12E and 12F, the A pack included an appropriate amount of the stock ceria dispersion described above in Example 1.

The B packs included 500 ppm by weight PVP (5000 g/mol), 2250 ppm by weight acetic acid, 3413 ppm by weight crotonic acid, 150 ppm Kordex MLX, and 0 ppm by weight (12A, 12C, and 12E) or 33.3 ppm by weight (12B, 12D, and 12F) ePLL (hydrochloride, free base).

One part of the A pack was first combined with 6 parts deionized water and then further combined with 3 parts of the B pack to obtain point of use compositions that included 0.2 weight percent ceria abrasive. Blanket TEOS wafers were polished for 60 seconds on a Mirra® tool at the conditions listed above. Polishing data are shown in Table 12. All removal rates are listed in angstroms per minute (Å/min).

Table 12

| Composition | ePLL POU (ppm) | TEOS RR |
|---|---|---|
| 12A | 0 | 4394 |
| 12B | 10 | 2512 |
| 12C | 0 | 8200 |
| 12D | 10 | 5766 |
| 12E | 0 | 5907 |
| 12F | 10 | 7025 |

As is readily apparent from the results set forth in Table 12, the TEOS removal rates increased at low levels of ePLL for compositions including the cubiform ceria abrasive particles (12E and 12F). In contrast the TEOS removal rates decreased at low levels of ePLL for compositions including the control cerias (12A-12D).

EXAMPLE 13

Seven polishing compositions were tested to evaluate the effect of epsilon polylysine (ePLL) on TEOS removal rate. Composition 13A was prepared by combining an A pack with deionized water and a corresponding B pack as described above in Example 5. The A pack included 1000 ppm by weight picolinic acid, 300 ppm by weight Kordex MLX and 2 weight percent ceria obtained from the stock ceria dispersion described above in Example 1. The B pack included 500 ppm by weight PVP (5000 g/mol), 2250 ppm by weight acetic acid, 3413 ppm by weight crotonic acid, 200 ppm by weight Polyquaternium-7, and 150 ppm by weight Kordek MLX The A and B packs were combined as described above in Example 5.

Compositions 13B-13G were made in a single pack and included 0.2 weight percent ceria abrasive particles obtained from the stock ceria dispersion described above in Example 1. Compositions 13B-13E further included 500 ppm by weight picolinic acid and 0 ppm by weight (13B), 1 ppm by weight (13C), 2 ppm by weight (13D), or 4 ppm by weight (13E) poly(vinylimidazolium) methyl sulfate (PVI). Compositions 13F and 13G included 100 ppm by weight picolinic acid and 5 ppm by weight (13F) or 10 ppm by weight ePLL.

Blanket TEOS wafers were polished for 60 seconds on a Mirra® tool at the conditions listed above. Polishing data are shown in Table 13. All removal rates are listed in angstroms per minute (Å/min).

Table 13

| Composition | Cationic Polymer | Picolinic Acid | TEOS RR |
|---|---|---|---|
| 13A | 60 ppm Polyquaternium-7 | 100 ppm | 4796 |

(continued)

| Composition | Cationic Polymer | Picolinic Acid | TEOS RR |
|---|---|---|---|
| 13B | 0 | 500 ppm | 5907 |
| 13C | 1 ppm PVI | 500 ppm | 6176 |
| 13D | 2 ppm PVI | 500 ppm | 6678 |
| 13E | 4 ppm PVI | 500 ppm | 7042 |
| 13F | 5 ppm ePLL | 100 ppm | 7751 |
| 13G | 10 ppm ePLL | 100 ppm | 5932 |

As is readily apparent from the results set forth in Table 13, the TEOS removal rate increases with low levels (1-5 ppm) of PVI and ePLL.

EXAMPLE 14

Three polishing compositions were tested to evaluate the effect of epsilon polylysine (ePLL) on TEOS, high density plasma (HDP) oxide, and SiN-PE removal rates. Compositions 14A-14C prepared by combining an A pack with deionized water and a corresponding B pack as described above in Example 5. The A pack for each composition included 1000 ppm by weight picolinic acid, 300 ppm by weight Kordex MLX and 2 weight percent ceria obtained from the stock ceria dispersion described above in Example 1.

The B pack for composition 14A was identical to the B pack for composition 13A described in Example 13. The B pack for compositions 14B and 14C included 500 ppm by weight PVP (5000 g/mol), 2250 ppm by weight acetic acid, 3413 ppm by weight crotonic acid, 33 ppm by weight ePLL (14B) or 100 ppm by weight ePLL (14C), and 150 ppm by weight Kordek MLX. The A and B packs were combined as described above in Example 5 such that composition 14B included 10 ppm by weight ePLL at POU and composition 14C included 30 ppm by weight ePLL at POU.

Blanket TEOS wafers, HDP oxide, and SiN-PE wafers were polished for 60 seconds on a Mirra® tool at the conditions listed above. Polishing data are shown in Table 14. All removal rates are listed in angstroms per minute (Å/min).

Table 14

| Composition | Cationic Polymer | TEOS RR | HDP RR | SiN-PE RR |
|---|---|---|---|---|
| 14A | 60 ppm Polyquaternium-7 | 5309 | 4254 | 9 |
| 14B | 10 ppm ePLL | 7385 | 6315 | 20 |
| 14C | 30 ppm ePLL | 1103 | 1196 | 17 |

As is readily apparent from the results set forth in Table 14, composition 14B achieves superior TEOS and HDP removal rates.

EXAMPLE 15

Five polishing compositions were tested to evaluate the effect of epsilon polylysine (ePLL) on TEOS removal rates on an Applied Materials Reflexion® polishing tool. Compositions 15A-15E were prepared using the stock ceria dispersion described above with respect to Example 1 and included 0.286 weight percent ceria abrasive particles. Compositions 15B, 15D, and 15E further included 143 ppm by weight picolinic acid. Compositions 15C, 15D, and 15E further included 5 ppm by weight (15C and 15D) or 10 ppm by weight (15E) ePLL.

Blanket TEOS wafers were polished for 60 seconds on a Reflexion® tool at a downforce of 3 psi, a platen speed of 93 rpm, a head speed of 87 rpm, and a slurry flow rate of 250 ml/min using a NexPlanar® E6088 polishing pad. The pad was conditioned in-situ using a Saesol DS8051 conditioner. Polishing data are shown in Table 15. All removal rates are listed in angstroms per minute (Å/min).

Table 15

| Composition | Picolinic Acid | ePLL | TEOS RR |
|---|---|---|---|
| 15A | 0 | 0 | 7688 |

(continued)

| Composition | Picolinic Acid | ePLL | TEOS RR |
|---|---|---|---|
| 15B | 142 ppm | 0 | 7279 |
| 15C | 0 | 5 ppm | 9246 |
| 15D | 142 ppm | 5 ppm | 9499 |
| 15E | 142 ppm | 10 ppm | 8078 |

As is readily apparent from the results set forth in Table 15, very high removal rates (approaching 10,000 A/min) may be achieved in compositions including cubiform ceria abrasive, picolinic acid, and ePLL.

EXAMPLE 16

Three polishing compositions were tested to evaluate the effect of lanthanum doping level in the cubiform ceria abrasive particles on the TEOS removal rate. Composition 16A included 0.28 weight percent of the first control ceria described above in Example 5. Composition 16B included 0.28 weight percent cubiform ceria abrasive particles including 2.5 mole percent lanthanum oxide and was prepared by diluting the stock ceria dispersion described above in Example 1 with 34 parts water to 1 part stock ceria dispersion. Composition 16C included 0.28 weight percent cubiform ceria abrasive particles including 10 mole percent lanthanum oxide and was prepared by diluting the ceria dispersion described in the following paragraphs with 34 parts water to 1 part ceria dispersion. Each of compositions 16A-16C had a pH of 4.

A cerium oxide dispersion was prepared as follows. A cerium nitrate solution was prepared by combining 11.5 kg of a 3 M trivalent cerium(III) nitrate solution, 1.3 kg of a 3 M lanthanum nitrate solution, 1.86 kg of a 68% nitric acid ($HNO_3$) solution, 0.5 kg deionized water, and cerium(IV) nitrate at a molar ratio of cerium(IV) to cerium(total) equal to 0.0000125 (1/80,235). The cerium nitrate solution was then degassed with agitation and nitrogen bubbling in a 20 L vessel.

An aqueous ammonia solution was prepared by combining 70 kg of deionized water and a solution of 14 kg of 25% aqueous ammonia (such that the molar ratio of $NH_4OH$ in the aqueous ammonia solution to the total cerium and lanthanum in the cerium nitrate solution was 10). The aqueous ammonia solution was then degassed with agitation and nitrogen bubbling in a 100 L vessel jacketed reactor.

The cerium nitrate solution was then added, at ambient temperature, to the aqueous ammonia solution with the same agitation under nitrogen purging. The temperature of the reaction mixture was then increased to 88 °C and held at that temperature for 13.5 hours. The reaction mixture was then left to cool and upon cooling was acidified to pH 2 by adding 68% nitric acid.

The reaction mixture was then filtrated and washed with deionized water. The washing was repeated when the conductivity of the washing solution was less than 0.04 mS/cm. Deionized water was added to adjust the final cubiform ceria abrasive concentration to 10 weight percent. The cubiform ceria abrasive particles included 10 mole percent lanthanum oxide and 90 mole percent cerium oxide.

The BET specific surface area was determined by nitrogen adsorption to be 8.6 $m^2$ per gram. The average particle size was 142 nm as measured by Malvern Zetasizer.

Blanket TEOS wafers were polished for 60 seconds on a Mirra® tool at the conditions listed above. Polishing results are shown in Table 16. All removal rates (RR) are listed in angstroms per minute (Å/min).

Table 16

| Composition | Abrasive | TEOS RR |
|---|---|---|
| 16A | First Control Ceria | 3819 |
| 16B | Cubiform Ceria with 2.5% La | 6388 |
| 16C | Cubiform Ceria with 10% La | 6285 |

As is readily apparent from the data set forth in Table 16, compositions 16B and 16C exhibited essentially equivalent TEOS removal rates that are greater than 1.6x the removal rate of the control composition 16A.

EXAMPLE 17

Two polishing compositions were tested to evaluate the effect of lanthanum doping level in the cubiform ceria abrasive particles on the TEOS removal rate. Compositions 17A and 17B were prepared by combining an A pack with deionized water and a corresponding B pack. The A packs included 1000 ppm by weight picolinic acid, 300 ppm by weight Kordek MLX biocide available from DuPont, and 2 weight percent cubiform abrasive particles. Composition 17A was prepared using the stock ceria dispersion described above in Example 1 including cubiform ceria abrasive particles having 2.5 percent lanthanum oxide. Composition 17B was prepared using the ceria dispersion described above in Example 16 including cubiform ceria abrasive particles having 10 percent lanthanum oxide. Each of the B packs included 500 ppm by weight PVP (5000 g/mol), 200 ppm by weight Polyquaternium-7, 2250 ppm by weight acetic acid, 3413 ppm by weight crotonic acid, and 150 ppm by weight Kordek MLX. biocide. The pH of both A and B packs was 4.

Blanket TEOS wafers were polished for 60 seconds on a Mirra® tool at the conditions listed above. Polishing results are shown in Table 17. All removal rates (RR) are listed in angstroms per minute (Å/min).

Table 17

| Composition | Abrasive | TEOS RR |
|---|---|---|
| 17A | Cubiform Ceria with 2.5% La | 4433 |
| 17B | Cubiform Ceria with 10% La | 23 |

It is readily apparent from the results set forth in Table 17 that composition 17A had a significantly higher TEOS removal rate than composition 17B.

EXAMPLE 18

One polishing composition concentrate was prepared to evaluate the effect of dilution with deionized water on blanket and patterned wafer polishing performance. The polishing composition concentrate included 300 ppm by weight PVP (5,000 g/mol), 100 ppm by weight Polyquaternium-7, 675 ppm by weight acetic acid, 1900 ppm by weight picolinic acid, 60 ppm Kordex MXL, and 0.2 weight percent of the cubiform ceria abrasive particles prepared as described above in Example 1. The pH of the concentrate was adjusted to 4.

The concentrate was diluted with deionized water to obtain four polishing compositions. Composition 18A was obtained by diluting one part of the concentrate with three parts deionized water. Composition 18B was obtained by diluting one part of the concentrate with seven parts deionized water. Composition 18C was obtained by diluting one part of the concentrate with eleven parts deionized water. Composition 18D was obtained by diluting one part of the concentrate with twenty-nine parts deionized water.

Blanket HDP wafers were polished for 30 seconds and patterned Silyb STI1 5k HDP filled wafers were polished to 100 percent overpolish on an Applied Materials Reflexion® tool and NexPlanar® E6088 polishing pad at a platen speed of 100 rpm, a head speed of 95 rpm, downforces of 3 and 1.7 psi, and a slurry flow rate of 200 ml/min with ex *situ* conditioning using a Saesol DS8051 conditioner at 6 pounds downforce for 12 seconds. The patterned wafers were polished at a downforce of 1.7 psi.

Polishing results are shown in Table 18. All removal rates are listed in angstroms per minute (Å/min). Dishing and SiN loss are listed in units of angstroms (Å).

Table 18

| Composition (dilution) | Point of Use Cubiform Ceria | HDP Rate (3 psi) | HDP Rate (1.7 psi) | SiN Loss | Dishing |
|---|---|---|---|---|---|
| 18A (4x) | 0.05 wt. % | 5831 | 2499 | 36 | 181 |
| 18B (8x) | 0.025 wt. % | 5140 | 2863 | 30 | 195 |
| 18C (12x) | 0.017 wt. % | 5026 | 3205 | 40 | 250 |
| 18D (40x) | 0.005 wt. % | 3026 | 2306 | 18 | 140 |

As is evident from the data set forth in Table 18, high HDP removal rates and excellent topography (low dishing and low SiN loss) can be achieved with highly diluted compositions having very low concentrations of cubiform ceria (50 ppm by weight cubiform ceria in this example).

EXAMPLE 19

Four polishing compositions were prepared to evaluate the effect of succinylated epsilon polylysine on TEOS, SiN and polysilicon removal rates. Each of the polishing compositions included 0.05 weight percent of the cubiform ceria abrasive particles prepared as described above in Example 1, 500 ppm by weight picolinic acid, 169 ppm by weight acetic acid, 75 ppm by weight PVP (500 g/mol), 100 ppm by weight Kordex MLX, and 25 or 60 ppm by weight cationic polymer at pH 4. Compositions 19A and 19B included 25 and 60 ppm by weight polyquaternium-7. Compositions 19C and 19D included 25 and 60 ppm by weight 40% succinylated epsilon polylysine (derivatized polylysine having a degree of derivatization of 0.4 as described in more detail in Example 1 of U.S. Provisional Patent Application Serial No. 62/958,033).

Blanket TEOS, SiN, and Polysilicon wafers were polished on an Applied Materials Mirra® polishing tool using an E6088 polishing pad at the polishing conditions described above. Polishing results are shown in Table 19. All removal rates are listed in angstroms per minute (Å/min).

Table 19

| Composition | Cationic Polymer | TEOS RR | SiN RR | PolySi RR |
|---|---|---|---|---|
| 19A | 25 ppm polyquaternium-7 | 6615 | 9 | 10 |
| 19B | 60 ppm polyquaternium-7 | 3632 | 10 | 12 |
| 19C | 25 ppm 40 % succinylated εPLL | 6761 | 10 | 16 |
| 19D | 60 ppm 40 % succinylated εPLL | 4473 | 10 | 22 |

As is apparent from the results set forth in Table 19, high TEOS removal rates and TEOS:SiN and TEOS:PolySi selectivities can be achieved in compositions including at least 60 ppm by weight of the 40 % succinylated εPLL cationic polymer indicating that the succinylated polylysine cationic polymers may provide a larger dose window, for example, than polyquaternium-7.

EXAMPLE 20

Five polishing compositions were prepared to evaluate the effect of succinylated epsilon polylysine on TEOS and SiN-PE removal rates. Compositions 20A-20D were prepared by combining an A pack with deionized water and a corresponding B pack as described above in Example 5. Composition 20E was prepared as a one-pack composition. The final compositions included 750 ppm by weight picolinic acid, 169 ppm by weight acetic acid, 50 ppm by weight benzisothiazolinone, 70 ppm by weight 40% succinylated epsilon polylysine (i.e., having a degree of derivatization of 0.4 as noted in Example 19), and 30 ppm by weight Kordex MLX. at pH 4 and either 0.063 (compositions 20A, 20B, and 2E) or 0.2 (compositions 2C and 2D) weight percent ceria.

The A-packs included 7500 ppm by weight picolinic acid, 300 ppm by weight Kordek MLX, and 0.63 weight percent (20A and 20B) or 2.0 weight percent (20C and 20D) ceria abrasive particles. For compositions 20A and 20C the sintered ceria abrasive used in polishing composition 1C of commonly assigned U.S. Patent 9,505,952 was used and for compositions 20B and 20D the stock ceria dispersion described in Example 1 was used. The pH value of each A pack was about 4. Each of the B-packs included 563 ppm by weight acetic acid, 233 ppm by weight 40% succinylated epsilon polylysine, and 166 ppm benzisothiazolinone. The pH of each B pack was about 4.

Blanket TEOS and SiN-PE wafers were polished for 30 seconds on a Logitech polishing tool at the conditions listed above for the Mirra® tool. Polishing results are shown in Table 20. All removal rates are listed in angstroms per minute (Å/min).

Table 20

| Composition | Ceria | Ceria (wt. %) | TEOS RR | SiN-PE RR | Selectivity |
|---|---|---|---|---|---|
| 20A | Sintered | 0.063 | 1560 | 8 | 196 |
| 20B | Cubiform | 0.063 | 3481 | 13 | 271 |
| 20C | Sintered | 0.2 | 1649 | 5 | 347 |
| 20D | Cubiform | 0.2 | 3967 | 14 | 288 |
| 20E (1pk) | Cubiform | 0.063 | 3295 | 11 | 307 |

As is apparent from the data set forth in Table 20, the compositions including the inventive cubiform ceria and succinylated epsilon polylysine (20B and 20D) achieved significantly higher TEOS removal rates (2x) than the compositions including calcined ceria (20A and 20C). Moreover, the 1 pack composition (20E) achieved similar performance to the comparable 2-pack composition (20B).

EXAMPLE 21

Seven polishing compositions were prepared to evaluate the effect of pH on the TEOS and SiN-PE removal rates as well as dishing performance. Compositions 21A-21G were prepared by on-platen mixing an A pack and a corresponding B pack at ratio of 7 parts A to 3 parts B. Each of the A packs included 800 ppm by weight cubiform ceria obtained from the stock ceria dispersion described in Example 1 and 1100 ppm by weight picolinic acid at pH 4. The B packs included either 166 ppm by weight Polyquaternium-7 (21A and 21B) or 250 ppm of the succinylated epsilon polylysine described above in Example 19 (21C, 21D, 21E, 21F, and 21G). The B packs for compositions 21C and 21D further included 312 ppm by weight polyvinylpyrrolidone. The pH of B packs 21A, 21C, and 21E was 4. The pH of B packs 21B, 21D, and 21F was 5. The pH of B pack 21G was 6. Table 21A summarizes the point of use polishing compositions.

**Table 21A**

| Composition | Cubiform Ceria | Cationic Polymer | Additive | pH |
|---|---|---|---|---|
| 21A | 0.056 wt.% | 50 ppm Polyquaternium-7 | | 4.0 |
| 21B | 0.056 wt.% | 50 ppm Polyquaternium-7 | | 4.6 |
| 21C | 0.056 wt.% | 75 ppm 40 % succinylated εPLL | 93 ppm PVP | 4.0 |
| 21D | 0.056 wt.% | 75 ppm 40 % succinylated εPLL | 93 ppm PVP | 4.7 |
| 21E | 0.056 wt.% | 75 ppm 40 % succinylated εPLL | | 4.0 |
| 21F | 0.056 wt.% | 75 ppm 40 % succinylated εPLL | | 4.6 |
| 21G | 0.056 wt.% | 75 ppm 40 % succinylated εPLL | | 5.0 |

Blanket TEOS wafers were polished for 30 seconds, blanket SiN-PE wafers were polished for 60 seconds, and patterned Silyb STI1 2.3k HDP filled wafers were polished to endpoint plus 50% on an Applied Materials Reflexion® tool and NexPlanar® E6088 polishing pad at a platen speed of 93 rpm, a head speed of 87 rpm, a downforce of 3 psi, and a slurry flow rate of 250 ml/min with *in situ* conditioning using a Saesol DS8051 conditioner at 6 pounds downforce. Polishing results are shown in Table 21B. All removal rates are listed in angstroms per minute (Å/min). Dishing is listed in angstroms (Å).

**Table 21B**

| Composition | TEOS RR | SiN RR | Dishing |
|---|---|---|---|
| 21A | 2600 | < 20 | 125 |
| 21B | 4500 | < 20 | 125 |
| 21C | 3700 | < 20 | 300 |
| 21D | 5300 | < 20 | 180 |
| 21E | 3000 | < 20 | 150 |
| 21F | 4500 | < 20 | 130 |
| 21G | 4700 | < 20 | 130 |

As is evident from the data set forth in Table 21B, high TEOS removal rates, low SiN removal rates (and therefore high TEOS:SiN selectivity), and low dishing can be achieved at pH values up to possibly exceeding pH 5.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein may be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein.

It will be understood that the disclosure includes numerous embodiments beyond those included above in the Examples. These embodiments include, but are not limited to the embodiments listed in the appended claims.

## Claims

1. A chemical mechanical polishing composition comprising:

    a liquid carrier;
    cubiform ceria abrasive particles dispersed in the liquid carrier; and
    a cationic polymer having a charge density of greater than about 6 milliequivalents per gram (meq/g).

2. The composition of claim 1, wherein optionally any one or more of the following applies,

    a) the cubiform ceria abrasive particles comprise a mixture of cerium oxide and lanthanum oxide;
    b) the cubiform ceria abrasive particles have a molar ratio of lanthanum to lanthanum plus cerium in a range from about 1 to about 15 percent;
    c) the cubiform ceria abrasive particles have a BET surface area in a range from about 3 $m^2/g$ to about 14 $m^2/g$;
    d) the cubiform ceria abrasive particles have an average particle size in a range from about 50 nm to about 500 nm; and
    e) the composition comprising from about 0.001 to about 1 weight percent of the cubiform ceria abrasive particles at point of use.

3. The composition of claim 1, wherein the cationic polymer has a charge density of greater than about 9 meq/g.

4. The composition of claim 1, wherein

    a) the cationic polymer comprises at least one of poly(vinylimidazole), poly(vinylimidazolium), poly(vinylmethyl imidazolium), epichlorhydrin-dimethylamine, polydiallyl dimethyl ammonium, poly(vinylmethyl imidazolium) methyl sulfate, polyethylenimine, polylysine, polyhistidine, polyarginine; or
    b) the cationic polymer is poly(vinylimidazolium), polylysine, or a mixture thereof.

5. The composition of claim 1, comprising

    a) from about 0.1 ppm by weight to about 20 ppm by weight of the cationic polymer at point of use; or
    b) from about 1 ppm by weight to about 10 ppm by weight of the cationic polymer at point of use.

6. The composition of claim 1, further comprising a carboxylic acid silicon oxide polishing rate enhancer, wherein optionally the carboxylic acid is picolinic acid, acetic acid, 4-hydroxybenzoic acid, or a mixture thereof.

7. The composition of claim 1, having a pH in a range from about 3 to about 6 at point of use.

8. The composition of claim 1, comprising:

    from about 0.001 to about 1 weight percent of the cubiform ceria abrasive particles at point of use; and
    from about 0.1 ppm by weight to about 20 ppm by weight poly(vinylimidazolium), polylysine, or a mixture thereof at point of use, wherein optionally the composition having a pH in a range from about 3 to 6 at point of use and further comprising picolinic acid, acetic acid, or a mixture thereof.

9. The composition of claim 1, comprising from about 0.001 to about 1 weight percent of the cubiform ceria abrasive particles at point of use, wherein:

    the cubiform ceria abrasive particles comprise a mixture of cerium oxide and lanthanum oxide and have an average particle size in a range from about 50 to about 500 nm; and

the cationic polymer includes poly(vinylimidazolium), polylysine, or a mixture thereof, wherein optionally the composition has a pH in a range from about 3 to 6 at point of use and further comprising picolinic acid, acetic acid, or a mixture thereof.

10. A method of chemical mechanical polishing a substrate including a silicon oxide dielectric material, the method comprising:

(a) providing a polishing composition including a liquid carrier, cubiform ceria abrasive particles dispersed in the liquid carrier, and a cationic polymer having a charge density of greater than about 6 meq/g;

(b) contacting the substrate with said provided polishing composition;

(c) moving said polishing composition relative to the substrate; and

(d) abrading the substrate to remove a portion of the silicon oxide dielectric material from the substrate and thereby polish the substrate.

11. The method of claim 10, wherein a removal rate of the silicon oxide dielectric material is greater than about 6,000 Å/min.

12. The method of claim 10, wherein the cationic polymer is polylysine or poly(vinylimidazolium).

13. The method of claim 10, wherein:

the polishing composition comprises from about 0.001 to about 1 weight percent of the cubiform ceria abrasive particles at point of use, and

the cubiform ceria abrasive particles comprise a mixture of cerium oxide and lanthanum oxide and have an average particle size in a range from about 50 to about 500 nm.

14. The method of claim 10, wherein the polishing composition further comprises picolinic acid, acetic acid, or a mixture thereof.


**Patentansprüche**

1. Zusammensetzung zum chemisch-mechanischen Polieren, umfassend:

einen flüssigen Träger;

Schleifteilchen aus kubischem Ceroxid, die in dem flüssigen Träger dispergiert sind; und

ein kationisches Polymer mit einer Ladungsdichte von mehr als etwa 6 Milliäquivalenten pro Gramm (meq/g).

2. Zusammensetzung nach Anspruch 1, wobei gegebenenfalls ein oder mehrere der folgenden Aussagen zutreffen:

a) die Schleifteilchen aus kubischem Ceroxid umfassen eine Mischung von Ceroxid und Lanthanoxid;

b) die Schleifteilchen aus kubischem Ceroxid weisen ein Molverhältnis von Lanthan zu Lanthan plus Cer in einem Bereich von etwa 1 bis etwa 15 Prozent auf;

c) die Schleifteilchen aus kubischem Ceroxid weisen eine BET-Oberfläche in einem Bereich von etwa 3 $m^2$/g bis etwa 14 $m^2$/g auf;

d) die Schleifteilchen aus kubischem Ceroxid weisen eine mittlere Teilchengröße in einem Bereich von etwa 50 nm bis etwa 500 nm auf; und

e) die Zusammensetzung umfasst etwa 0,001 bis etwa 1 Gewichtsprozent der Schleifteilchen aus kubischem Ceroxid am Verwendungspunkt.

3. Zusammensetzung nach Anspruch 1, wobei das kationische Polymer eine Ladungsdichte von mehr als etwa 9 meq/g aufweist.

4. Zusammensetzung nach Anspruch 1, wobei

a) das kationische Polymer mindestens eines von Poly(vinylimidazol), Poly(vinylimidazolium), Poly(vinylmethylimidazolium), Epichlorhydrin-Dimethylamin, Polydiallyldimethylammonium, Poly(vinylmethylimidazolium)methylsulfat, Polyethylenimin, Polylysin, Polyhistidin, Polyarginin umfasst; oder

b) es sich bei dem kationischen Polymer um Poly(vinylimidazolium), Polylysin oder eine Mischung davon handelt.

5. Zusammensetzung nach Anspruch 1, umfassend

   a) etwa 0,1 Gew.-ppm bis etwa 20 Gew.-ppm des kationischen Polymers am Verwendungspunkt; oder

   b) etwa 1 Gew.-ppm bis etwa 10 Gew.-ppm des kationischen Polymers am Verwendungspunkt.

6. Zusammensetzung nach Anspruch 1, ferner umfassend einen Carbonsäure-Siliciumoxid-Polierratenverbesserer, wobei es sich bei der carbonsäure gegebenenfalls um Picolinsäure, Essigsäure, 4-Hydroxybenzoesäure oder eine Mischung davon handelt.

7. Zusammensetzung nach Anspruch 1 mit einem pH-Wert in einem Bereich von etwa 3 bis etwa 6 am Verwendungspunkt.

8. Zusammensetzung nach Anspruch 1, umfassend:

   etwa 0,001 bis etwa 1 Gewichtsprozent der Schleifteilchen aus kubischem Ceroxid am Verwendungspunkt; und
   etwa 0,1 Gew.-ppm bis etwa 20 Gew.-ppm Poly(vinylimidazolium), Polylysin oder einer Mischung davon am Verwendungsort, wobei die Zusammensetzung gegebenenfalls einen pH-Wert in einem Bereich von etwa 3 bis 6 am Verwendungspunkt aufweist und ferner Picolinsäure, Essigsäure oder eine Mischung davon umfasst.

9. Zusammensetzung nach Anspruch 1, umfassend etwa 0,001 bis etwa 1 Gewichtsprozent der Schleifteilchen aus kubischem Ceroxid am Verwendungspunkt, wobei:

   die Schleifteilchen aus kubischem Ceroxid eine Mischung von Ceroxid und Lanthanoxid umfassen und eine mittlere Teilchengröße in einem Bereich von etwa 50 bis etwa 500 nm aufweisen; und
   das kationische Polymer Poly(vinylimidazolium), Polylysin oder eine Mischung davon enthält, wobei die Zusammensetzung gegebenenfalls einen pH-Wert in einem Bereich von etwa 3 bis 6 am Verwendungspunkt aufweist, und ferner Picolinsäure, Essigsäure oder eine Mischung davon umfasst.

10. Verfahren zum chemisch-mechanischen Polieren eines Substrats, das ein dielekrtisches Siliciumoxidmaterial enthält, wobei das Verfahren Folgendes umfasst:

    (a) Bereitstellen einer Polierzusammensetzung, enthaltend einen flüssigen Träger, Schleifteilchen aus kubischem Ceroxid, die in dem flüssigen Träger dispergiert sind, und ein kationisches Polymer mit einer Ladungsdichte von mehr als etwa 6 meq/g;
    (b) Inkontaktbringen des Substrats mit der bereitgestellten Polierzusammensetzung;
    (c) Bewegen der Polierzusammensetzung relativ zu dem Substrat; und
    (d) Schleifen des Substrats zur Entfernung eines Teils des dielektrischen Siliciumoxidmaterials von dem Substrat und dadurch Polieren des Substrats.

11. Verfahren nach Anspruch 10, wobei eine Abtragsrate des dielektrischen Siliciumoxidmaterials größer als etwa 6000 Å/min ist.

12. Verfahren nach Anspruch 10, wobei es sich bei dem kationischen Polymer um Polylysin oder Poly(vinylimidazolium) handelt.

13. Verfahren nach Anspruch 10, wobei:

    die Polierzusammensetzung etwa 0,001 bis etwa 1 Gewichtsprozent der Schleifteilchen aus kubischem Ceroxid am Verwendungspunkt umfasst und
    die Schleifteilchen aus kubischem Ceroxid eine Mischung von Ceroxid und Lanthanoxid umfassen und eine mittlere Teilchengröße in einem Bereich von etwa 50 bis etwa 500 nm aufweisen.

14. Verfahren nach Anspruch 10, wobei die Polierzusammensetzung ferner Picolinsäure, Essigsäure oder eine Mischung davon umfasst.

**Revendications**

1. Composition de polissage mécano-chimique comprenant :

   un support liquide ;
   des particules abrasives cubiformes d'oxyde de cérium dispersées dans le support liquide ; et
   un polymère cationique ayant une densité de charge supérieure à environ 6 milliéquivalents par gramme (méq/g).

2. Composition selon la revendication 1, dans laquelle éventuellement un ou plusieurs des éléments suivants s'appliquent,

   a) les particules abrasives cubiformes d'oxyde de cérium comprennent un mélange d'oxyde de cérium et d'oxyde de lanthane ;
   b) les particules abrasives cubiformes d'oxyde de cérium ont un rapport molaire du lanthane sur lanthane plus cérium dans une plage d'environ 1 à environ 15 pour cent ;
   c) les particules abrasives cubiformes d'oxyde de cérium ont une surface BET dans une plage d'environ 3 $m^2/g$ à environ 14 $m^2/g$ ;
   d) les particules abrasives cubiformes d'oxyde de cérium ont une taille moyenne de particule dans une plage d'environ 50 nm à environ 500 nm ; et
   e) la composition comprenant d'environ 0,001 à environ 1 pour cent en poids des particules abrasives cubiformes d'oxyde de cérium au point d'utilisation.

3. Composition selon la revendication 1, dans laquelle le polymère cationique a une densité de charge supérieure à environ 9 méq/g.

4. Composition selon la revendication 1, dans laquelle

   a) le polymère cationique comprend au moins l'un parmi un poly(vinylimidazole), poly(vinylimidazolium), poly(vinylméthyl imidazolium), épichlorhydrine-diméthylamine, polydiallyl diméthyl ammonium, méthylsulfate de poly(vinylméthyl imidazolium), polyéthylèneimine, polylysine, polyhistidine, polyarginine ; ou
   b) le polymère cationique est un poly(vinylimidazolium), une polylysine ou un mélange de ceux-ci.

5. Composition selon la revendication 1, comprenant

   a) d'environ 0,1 ppm en poids à environ 20 ppm en poids du polymère cationique au point d'utilisation ; ou
   b) d'environ 1 ppm en poids à environ 10 ppm en poids du polymère cationique au point d'utilisation.

6. Composition selon la revendication 1, comprenant en outre un agent améliorant la vitesse de polissage d'oxyde de silicium de type acide carboxylique, dans laquelle éventuellement l'acide carboxylique est l'acide picolinique, l'acide acétique, l'acide 4-hydroxybenzoïque ou un mélange de ceux-ci.

7. Composition selon la revendication 1, ayant un pH dans une plage d'environ 3 à environ 6 au point d'utilisation.

8. Composition selon la revendication 1, comprenant :

   d'environ 0,001 à environ 1 pour cent en poids des particules abrasives cubiformes d'oxyde de cérium au point d'utilisation ; et
   d'environ 0,1 ppm en poids à environ 20 ppm en poids de poly(vinylimidazolium), polylysine, ou d'un mélange de ceux-ci au point d'utilisation, dans laquelle éventuellement la composition a un pH dans une plage d'environ 3 à 6 au point d'utilisation et comprenant en outre de l'acide picolinique, de l'acide acétique ou un mélange de ceux-ci.

9. Composition selon la revendication 1, comprenant d'environ 0,001 à environ 1 pour cent en poids des particules abrasives cubiformes d'oxyde de cérium au point d'utilisation, dans laquelle :

   les particules abrasives cubiformes d'oxyde de cérium comprennent un mélange d'oxyde de cérium et d'oxyde de lanthane et ont une taille moyenne de particule dans une plage d'environ 50 à environ 500 nm ; et
   le polymère cationique comprend un poly(vinylimidazolium), une polylysine ou un mélange de ceux-ci, dans laquelle éventuellement la composition a un pH dans une plage d'environ 3 à 6 au point d'utilisation et comprenant en outre de l'acide picolinique, de l'acide acétique ou un mélange de ceux-ci.

10. Procédé de polissage mécano-chimique d'un substrat comprenant un matériau diélectrique d'oxyde de silicium, le procédé comprenant :

(a) la fourniture d'une composition de polissage comprenant un support liquide, des particules abrasives cubiformes d'oxyde de cérium dispersées dans le support liquide et un polymère cationique ayant une densité de charge supérieure à environ 6 méq/g ;
(b) la mise en contact du substrat avec ladite composition de polissage fournie ;
(c) le déplacement de ladite composition de polissage par rapport au substrat ; et
(d) l'abrasion du substrat pour éliminer une partie du matériau diélectrique d'oxyde de silicium du substrat et ainsi polir le substrat.

11. Procédé selon la revendication 10, dans lequel une vitesse d'élimination du matériau diélectrique d'oxyde de silicium est supérieure à environ 6 000 Å/min.

12. Procédé selon la revendication 10, dans lequel le polymère cationique est une polylysine ou un poly(vinylimidazolium).

13. Procédé selon la revendication 10, dans lequel : la composition de polissage comprend d'environ 0,001 à environ 1 pour cent en poids des particules abrasives cubiformes d'oxyde de cérium au point d'utilisation, et les particules abrasives cubiformes d'oxyde de cérium comprennent un mélange d'oxyde de cérium et d'oxyde de lanthane et ont une taille moyenne de particule dans une plage d'environ 50 à environ 500 nm.

14. Procédé selon la revendication 10, dans lequel la composition de polissage comprend en outre de l'acide picolinique, de l'acide acétique ou un mélange de ceux-ci.

FIG. 1

FIG. 2

FIG. 3

## REFERENCES CITED IN THE DESCRIPTION

**Patent documents cited in the description**

- US 62924328
- US 62958033

- US 9505952 B